# EUROPEAN PATENT APPLICATION

(11) **EP 4 542 304 A1**
(43) Date of publication of application: **23.04.2025**
(21) Application number: 24203027.8
(22) Date of filing: 26.09.2024
(51) Int. Cl.: G03F 7/09, G03F 7/11, G03F 7/00

(54) **COMPOSITION FOR FORMING RESIST UNDERLAYER FILM, RESIST UNDERLAYER FILM, METHOD FOR MANUFACTURING RESIST UNDERLAYER FILM, PATTERNING PROCESS, AND METHOD FOR MANUFACTURING SEMICONDUCTOR DEVICE**

(30) Priority: 20.10.2023 JP 2023180975
(71) Applicant: SHIN-ETSU CHEMICAL CO., LTD., Tokyo 1000005 (JP)
(72) Inventor: Iwamori, Shohei, Niigata (JP); Satoh, Hironori, Niigata (JP); Kori, Daisuke, Niigata (JP)
(74) Representative: Sonnenhauser, Thomas Martin

(57) **Abstract**

The present invention is a composition for forming a resist underlayer film, containing: (A) a polyether compound containing a repeating unit represented by the following general formula (I); and (B) an organic solvent, where Ar₁ represents a substituted or unsubstituted aryl group having 6 to 30 carbon atoms or the like, R₁ represents a substituted or unsubstituted, linear, branched, or cyclic, saturated or unsaturated divalent hydrocarbon group having 1 to 20 carbon atoms or a substituted or unsubstituted, linear, branched, or cyclic heteroalkylene group having 1 to 20 carbon atoms, and "n" and "m" each represent an integer of 0 or more. This can provide a composition for forming a resist underlayer film with which it is possible to form a resist underlayer film that exhibits excellent processing resistance and excellent gas permeability.

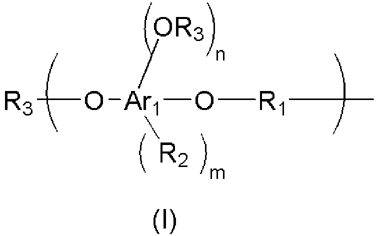

## Description

### TECHNICAL FIELD

The present invention relates to: a composition for forming a resist underlayer film; a resist underlayer film; a method for manufacturing a resist underlayer film; a patterning process; and a method for manufacturing a semiconductor device. In particular, the present invention relates to a composition for forming a resist underlayer film for nanoimprinting usable for fine patterning according to a photo-nanoimprinting method in a semiconductor device manufacturing process.

### BACKGROUND ART

In the production of semiconductor devices, MEMS, etc., which require miniaturization, photo-nanoimprinting technology, according to which it is possible to form a fine structure on a substrate in the order of several nanometers, is attracting attention. In a common photo-nanoimprinting technique, firstly, a liquid resist composition is dropped onto a substrate in a pattern-formation region by an inkjet method or the like, and the droplets of the resist composition are spread on the substrate (prespreading). Then, the resist composition is molded using a mold that is transparent to irradiation light and has a formed pattern. In this event, the droplets of the resist composition are spread over the entire gap between the substrate and the mold by capillarity (spreading). The resist composition also fills the inside of concave portions of the mold by capillarity (filling). The time until the spreading and the filling are completed is filling time. After the filling with the resist composition has been completed, irradiation with light is performed to cure the resist composition, and then the two are separated. By performing these steps, a resist pattern having a predetermined shape is formed on the substrate.

In the releasing step of the photo-nanoimprinting technique, the adhesiveness between the resist composition and the substrate is important. This is because if the adhesiveness between the resist composition and the substrate is low, pattern delamination defects are generated in some cases, and a part of the photo-cured product obtained by curing the resist composition adheres to the mold and is peeled off when the mold is pulled off in the releasing step. In this background, as a technique for enhancing adhesiveness between a resist composition and a substrate, there is a proposal for a technique of forming an adhesive layer, which is a layer for allowing a resist composition and a substrate to adhere to each other, between the resist composition and the substrate (Patent Document 1).

Meanwhile, Patent Document 2 discloses an inverting process in nanoimprinting. Since Spin On Carbon (SOC) is used as a layer to be processed, properties such as processing resistance, filling property, and flatness are needed. In addition, a process of nanoimprinting on SOC is generally performed by applying onto SOC an adhesive layer material for nanoimprinting and performing imprinting thereon. In addition, molding failure and so forth occurs due to bubbles generated when a mold is pressed against a curable composition (resist), and therefore, it is necessary to eliminate the generated bubbles. In Patent Document 3, the oxygen permeability on the side of the mold is improved, but with miniaturization, further improvement of defoaming property is expected. From such a background, it is proposed to eliminate gases from the side of an underlayer film, and there are demands for the development of an underlayer film having high gas permeability (Non Patent Document 1).

A hydrophobic film tends to have higher permeability of a gas if the gas is hydrophobic, and a hydrophilic film tends to have higher permeability of a gas if the gas has high hydrophilicity. As the atmosphere in the step of pressing the mold, a comparatively hydrophobic gas, such as He, H₂, N₂, and air, is selected, and therefore, Patent Document 4 and Patent Document 5 propose a highly hydrophobic film, having a high contact angle with water, as an underlayer film material. However, in these documents, there is no discussion of the actual gas permeability. Moreover, in reality, there is also a possibility that a gas having comparatively high hydrophilicity, such as CO₂, may be selected. Meanwhile, it is known that gas permeability is greatly influenced not only by hydrophilicity and hydrophobicity but also by film density and additives.

### CITATION LIST

### PATENT LITERATURE

Patent Document 1: JP2013-202982A
Patent Document 2: JP2006-524919A
Patent Document 3: JP6703253B2
Patent Document 4: WO2021-125036A1
Patent Document 5: WO2023-145923A1

### NON PATENT LITERATURE

Non Patent Document 1: Proc. SPIE 10958, Novel Patterning Technologies for Semiconductors, MEMS/NEMS, and MOEMS 2019, 109580H

### SUMMARY OF INVENTION

### TECHNICAL PROBLEM

The present invention has been made in view of the above-described circumstances. An object of the present invention is to provide: a composition for forming a resist underlayer film with which it is possible to form a resist underlayer film that exhibits excellent processing resistance and excellent gas permeability; a resist underlayer film, being a cured product of a coating film formed from the composition; a method for manufacturing a resist underlayer film by using the composition; a patterning process using the composition; and a method for manufacturing a semiconductor device by using the composition.

### SOLUTION TO PROBLEM

To achieve the object, the present invention provides a composition for forming a resist underlayer film, comprising:
(A) a polyether compound containing a repeating unit represented by the following general formula (I); and
(B) an organic solvent, 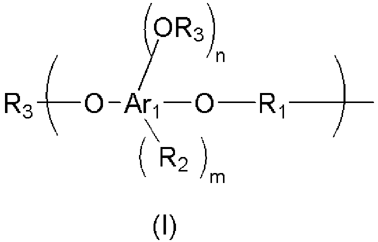
wherein Ar₁ represents a substituted or unsubstituted aryl group having 6 to 30 carbon atoms, a substituted or unsubstituted heteroaryl group having 6 to 30 carbon atoms, a substituted or unsubstituted aryl group having 6 to 30 carbon atoms fused or linked with an aliphatic ring or a heterocycle, or a plurality of substituted or unsubstituted aryl groups each having 6 to 30 carbon atoms and linked with each other via a linear, branched, or cyclic hydrocarbon group, an ether group, or a carbonyl group, Ar₁ being of one kind or a combination of two or more kinds within a single resin, R₁ represents a substituted or unsubstituted, linear, branched, or cyclic, saturated or unsaturated divalent hydrocarbon group having 1 to 20 carbon atoms or a substituted or unsubstituted, linear, branched, or cyclic heteroalkylene group having 1 to 20 carbon atoms, R₂ represents a substituted or unsubstituted, linear, branched, or cyclic, saturated or unsaturated hydrocarbon group having 1 to 20 carbon atoms, a substituted or unsubstituted heteroalkyl group having 1 to 20 carbon atoms, an amino group, a thiol group, or a halogen atom, R₃ is of one kind or a combination of two or more kinds within a single resin and represents a hydrogen atom, a substituted or unsubstituted, linear, branched, or cyclic alkyl group having 1 to 20 carbon atoms, a substituted or unsubstituted, linear, branched, or cyclic alkenyl group having 2 to 20 carbon atoms, or a substituted or unsubstituted, linear, branched, or cyclic alkynyl group having 2 to 20 carbon atoms, and "n" and "m" each represent an integer of 0 or more.

The above-described polyether compound contains an aromatic ring in the Ar₁ in the polymer main chain, and therefore, is excellent in mechanical strength (also referred to as processing resistance) for withstanding processing. Meanwhile, by polyetherifying the Ar₁, using the linear, branched, or cyclic hydrocarbon group or heteroalkylene group represented by R₁ and the ether group as linkers, it is possible to suppress close packing of aromatic rings and a dense crosslinking reaction, and suppress the densification of a film. By appropriately performing the selection of the main skeleton structure and the substituent structure in this manner, it is possible to achieve both processing resistance and gas permeability, which are conflicting properties. In addition, flowability can be provided by the R₁ and the ether group, which are linkers, and therefore, it is also possible to realize excellent filling property and excellent flatness. Therefore, according to the present invention, it is possible to provide a resist underlayer film which has excellent hardness and exhibits mechanical strength to withstand processing (has excellent processing resistance), has excellent filling property and flatness, and also has low film density and can be expected to exhibit excellent gas permeability.

Furthermore, by introducing multiple substituents, such as the optional R₂ and the optional R₃, thermal flowability can also be provided. In addition, the steric hindrance of the optional substituent R₂ or the optional substituent containing the R₃ introduced via an ether structure makes it possible further to suppress close packing of aromatic rings and a dense crosslinking reaction, and further suppress the densification of a film.

It is preferable that at least one of the R₃ in the general formula (I) is a structure R_{II-1} selected from the group consisting of groups represented by the following formulae (II-1), and a proportion "a" of the structure R_{II-1} is 1 ≤ a ≤ 100, 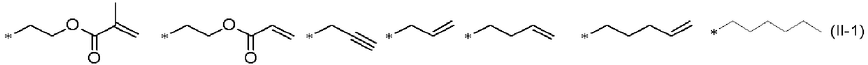 wherein "*" represents an attachment point to the oxygen atom.

When at least one of the R₃ in the general formula (I) is a structure R_{II-1} selected from the group consisting of groups represented by the general formulae (II-1), the steric hindrance of the structure makes it possible to suppress further the packing of aromatic rings, and prevent further the densification of a film. In addition, by end-capping a hydroxy group, hydrophobicity can be enhanced, so that it is possible to enhance affinity to hydrophobic gases, such as He and N₂, and improve the permeability of these gases. Furthermore, out of the structures R_{II-1}, those which contain an unsaturated bond make it possible to impart crosslinking property to the compound itself. Therefore, when the R₃ which has the structure R_{II-1} containing an unsaturated bond is contained, it is possible to provide a resist underlayer film that can undergo self-crosslinking, has low film density, and furthermore, is hydrophobic.

It is preferable that the R₃ in the general formula (I) is a combination of a structure R_{II-1} selected from the group consisting of groups represented by the following formulae (II-1) and a structure R_{II-2} selected from the group consisting of groups represented by the following formulae (II-2), and a proportion "a" of the structure R_{II-1} and a proportion "b" of the structure R_{II-2} satisfy relationships 1 ≤ a ≤ 99, 1 ≤ b ≤ 99, and a + b = 100, 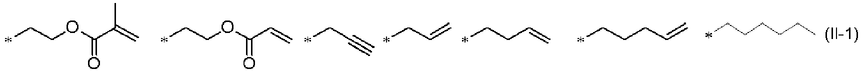 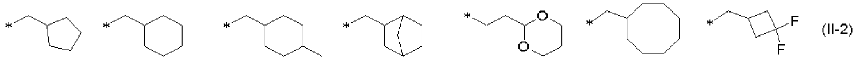 wherein "*" represents an attachment point to the oxygen atom.

When at least one of the R₃ in the general formula (I) has a structure R_{II-2} selected from the group consisting of groups represented by the general formulae (II-2), there is little risk of processing resistance being degraded since the polyether compound has a cyclic structure, and on the other hand, the cyclic structure itself has low density and also has great steric hindrance, and therefore, the compound has a high effect of preventing aromatic rings from adjoining each other densely and a film having low film density can be achieved. In addition, when at least one of the R₃ has the structure R_{II-1} selected from the group consisting of the groups represented by the general formulae (II-1) containing an unsaturated bond, a self-crosslinkable film can be achieved. Furthermore, by end-capping the hydroxy group of the R₃ with the structures, the polarity of the compound can be reduced, and it is possible to improve the permeability of gases, such as He, H₂, N₂, and air, which are hydrophobic. Furthermore, when R₃ is a combination of multiple substituents, it is possible to reduce the crystallinity of the resin and also enhance thermal flowability. That is, when such a compound is contained in a composition, it is possible to provide a resist underlayer film that has low film density and exhibits excellent gas permeability, and is also excellent in processing resistance, filling property, and flatness.

The R₁ in the general formula (I) is preferably selected from the group consisting of groups represented by the following general formulae (III-1) to (III-3), 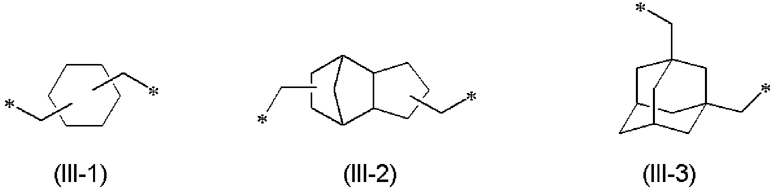 wherein "*" represents an attachment point to the oxygen atom.

When the R₁ in the general formula (I) is selected from the group consisting of the groups represented by the general formulae (III-1) to (III-3), there is little risk of processing resistance being degraded since the polyether compound has a cyclic structure, and on the other hand, the cyclic structure itself has low density and also has great steric hindrance, and therefore, the compound has a high effect of preventing aromatic rings from adjoining each other densely and a film having low film density can be achieved. That is, the composition in this preferable aspect can provide a resist underlayer film that exhibits better processing resistance and higher gas permeability.

The Ar₁ in the general formula (I) is preferably selected from the group consisting of structures represented by the following formulae (Ar-1), 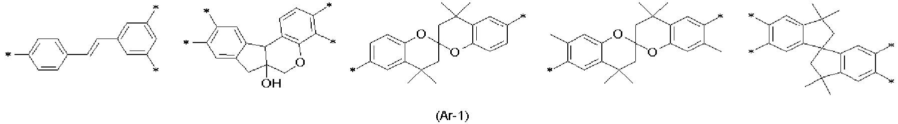 wherein "*" represents an attachment point to the oxygen atom of the -O-R₁- or OR₃.

Every structure represented by the formulae (Ar-1) has two benzene rings within a single structure, and therefore, exhibits excellent processing resistance. Furthermore, when the rings are bonded to each other or fused with each other via an alkylene chain or an ether chain, for example, the structure has a spiro structure having a three-dimensionally distorted structure, the structure can suppress the packing of aromatic rings with each other, and it is possible to suppress the densification of the film after baking. Therefore, the composition in this preferable aspect makes it possible to provide a resist underlayer film that exhibits better gas permeability.

The polyether compound preferably has a weight-average molecular weight Mw of 2000 to 12000 as measured by gel permeation chromatography in terms of polystyrene.

When the polyether compound has a weight-average molecular weight Mw of 2000 to 12000, low-molecular-weight components, which cause sublimation at the time of baking, are reduced, and therefore, film formation failure hardly occurs; and the composition for forming a resist underlayer film can also prevent filling property failure being induced by degradation in thermal flowability due to excessive molecular weight.

It is preferable that 101 < {(FT-2)/(FT-1)} × 100 is satisfied,
wherein the FT-1 is a film thickness of a coating film of the composition for forming a resist underlayer film applied onto a substrate, the coating film having been subjected to baking at 180°C for 60 seconds and additional baking at 350°C for 60 seconds, and
the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.

101 < {(FT-2)/(FT-1)} × 100 indicates that, compared to the film immediately after baking, the film after reworking has swollen, and it is thought that, immediately after baking, a porous film, having many fine pores that OK73 thinner can soak into, is formed. It is suggested that a film having low film density is formed, rather than a dense film.

The composition preferably further comprises (C) a surfactant.

When the inventive composition for forming a resist underlayer film contains a surfactant (C), it is possible to suppress film formation failure, such as striations on the film surface, and disturbance in in-plane uniformity.

It is also preferable that the composition further comprises (D) a crosslinking agent, wherein
100 < {(FT-2)/(FT-1)} × 100 < 103 is satisfied,
wherein the FT-1 is a film thickness of a coating film of the composition for forming a resist underlayer film applied onto a substrate, the coating film having been subjected to baking at 180°C for 60 seconds and additional baking at 350°C for 60 seconds, and
the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.

Even if curing with only the polyether compound is insufficient, by virtue of the crosslinking agent (D), curing can be promoted, and it is possible not only to raise the hardness of the film and strengthen the processing resistance but also to suppress the swelling of the film after reworking, and therefore, the porosity of the film can be adjusted.

It is also preferable that the composition further comprises (E) a thermally decomposable resin, wherein
101.5 < {(FT-2)/(FT-1)} × 100 is satisfied,
wherein the FT-1 is a film thickness of a coating film of the composition for forming a resist underlayer film applied onto a substrate, the coating film having been subjected to baking at 180°C for 60 seconds and additional baking at 350°C for 60 seconds, and
the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.

When the inventive composition for forming a resist underlayer film further contains a thermally decomposable resin (E), the thermally decomposable resin is decomposed at the time of baking and sublimates from within the film, and thus, more pores can be formed in the film. Therefore, according to the composition in this preferable aspect, the swelling of the film after reworking increases, so that the degree of porousness of the film can be adjusted.

The composition may further comprise both (D) a crosslinking agent and (E) a thermally decomposable resin, wherein
100 < {(FT-2)/(FT-1)} × 100 is satisfied,
wherein the FT-1 is a film thickness of a coating film of the composition for forming a resist underlayer film applied onto a substrate, the coating film having been subjected to baking at 180°C for 60 seconds and additional baking at 350°C for 60 seconds, and
the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.

The crosslinking agent (D) and the thermally decomposable resin (E) have conflicting effects from the viewpoint of adjusting the porosity of the film, and therefore, when the two are both contained, it is sufficient to be able to observe only the curing of the film. Therefore, the film thicknesses of before and after reworking can be (FT-2) > (FT-1) when compared.

It is also preferable for the composition to comprise further (F) an acid generator.

When an acid generator (F) is contained, the curability of the resin and the decomposability of the thermally decomposable resin can be enhanced in some cases.

The inventive composition for forming a resist underlayer film may be for nanoimprinting.

The intended use of a resist underlayer film formed from the inventive composition is not particularly limited. For example, the inventive composition for forming a resist underlayer film may be for nanoimprinting. A resist underlayer film formed from the inventive composition for forming a resist underlayer film can have excellent processing resistance, have excellent filling property and flatness, and also have low film density and exhibit excellent gas permeability. Therefore, the inventive composition makes it possible to realize a resist underlayer film that is very useful for nanoimprinting.

The present invention also provides a resist underlayer film, being a cured product of a coating film comprising the inventive composition for forming a resist underlayer film.

The resist underlayer film formed from the inventive composition for forming a resist underlayer film can have favorable processing resistance, have excellent filling property and flatness, and also have low film density, so that the resist underlayer film can exhibit favorable gas permeability.

The present invention also provides a method for manufacturing a resist underlayer film, comprising:
applying the inventive composition for forming a resist underlayer film onto a semiconductor substrate to obtain a coating film; and
baking the coating film to obtain a resist underlayer film.

According to the inventive method for manufacturing a resist underlayer film as described, the inventive composition for forming a resist underlayer film is used, and therefore, it is possible to realize a resist underlayer film that can have favorable processing resistance, have excellent filling property and flatness, and also have low film density, so that the resist underlayer film can exhibit favorable gas permeability.

The present invention also provides a patterning process comprising the steps of:
forming a resist underlayer film on a semiconductor substrate by using the inventive composition for forming a resist underlayer film;
forming a curable composition film on the resist underlayer film;
bringing the curable composition film into contact with a mold;
irradiating the curable composition film with light or an electron beam to obtain a cured film; and
separating the cured film from the mold.

In the inventive patterning process according to an imprinting method as described, it is possible to use a resist underlayer film having favorable processing resistance, having excellent filling property and flatness, furthermore, having low film density, and exhibiting favorable gas permeability. Therefore, according to the inventive patterning process by way of the imprinting method, bubbles generated when the mold is pressed against the curable composition film can be eliminated quickly, and it is possible to form a fine pattern.

The step of forming the curable composition film on the resist underlayer film may also include: forming an adhesive layer and/or a silicone layer containing 99 mass% or less Si on the resist underlayer film by application or deposition; and forming the curable composition film thereon.

By forming an adhesive layer, pattern delamination can be sufficiently suppressed in the step of pulling the mold off. Meanwhile, by forming a silicone layer containing 99 mass% or less Si, the optical characteristics of the film can be adjusted, and it is possible to control reflection and so forth.

The present invention also provides a method for manufacturing a semiconductor device, comprising the steps of:
forming a resist underlayer film on a semiconductor substrate by using the inventive composition for forming a resist underlayer film;
forming a resist film on the resist underlayer film;
subjecting the resist film to irradiation with light or an electron beam and then to development to form a resist pattern;
etching the resist underlayer film while using the formed resist pattern as a mask to obtain a patterned underlayer film; and
processing the semiconductor substrate while using the patterned underlayer film as a mask.

The present invention also provides a method for manufacturing a semiconductor device, comprising the steps of:
forming a resist underlayer film on a semiconductor substrate by using the inventive composition for forming a resist underlayer film;
forming a hard mask on the resist underlayer film;
further forming a resist film on the hard mask;
subjecting the resist film to irradiation with light or an electron beam and then to development to form a resist pattern;
etching the hard mask while using the formed resist pattern as a mask to obtain a patterned hard mask;
etching the underlayer film while using the patterned hard mask as a mask to obtain a patterned resist underlayer film; and
processing the semiconductor substrate while using the patterned resist underlayer film as a mask.

The inventive composition for forming a resist underlayer film can provide a resist underlayer film that can have favorable processing resistance, have excellent filling property and flatness, also have low film density, and exhibit favorable gas permeability, and therefore, as described above, is also useful for patterning processes other than nanoimprinting methods, for example, methods for manufacturing a semiconductor device according to a multilayer resist method. That is, according to the inventive methods for manufacturing a semiconductor device, a fine pattern can be formed in a semiconductor substrate.

### ADVANTAGEOUS EFFECTS OF INVENTION

As described above, the inventive composition for forming a resist underlayer film contains (A) a polyether compound having a repeating unit structure represented by the general formula (I) and (B) an organic solvent, and contains an aromatic ring in the polyether compound (A), so that sufficient mechanical strength for withstanding processing, favorable filling property, and favorable flatness can be realized. Meanwhile, the aromatic rings are polyetherified with a linear, branched, or cyclic hydrocarbon group or heteroalkylene group or an ether group as a linker, and therefore, close packing of the aromatic rings and a dense crosslinking reaction can be inhibited, so that the densification of the film can be suppressed. Therefore, the inventive composition for forming a resist underlayer film makes it possible to provide a resist underlayer film that can have favorable processing resistance, filling property, and flatness, can also have low film density, and can be expected to exhibit favorable gas permeability.

Furthermore, the polyether compound (A) may also have multiple substituents, and packing and a dense crosslinking reaction can be further inhibited particularly by an ether substituent R₃ or another substituent R₂ on the aromatic ring. In addition, when the compound has multiple substituents, the crystallinity of the polymer can be suppressed, and further thermal flowability can also be provided.

The inventive composition for forming a resist underlayer film may be a composition in which the film thickness (FT-1) and the film thickness (FT-2) satisfy, for example, 101 < {(FT-2)/(FT-1)} × 100. This relationship between the film thicknesses indicates that the film has swollen, and that the film is porous and has fine pores for the solvent to soak into. If a dense curing reaction occurs as in an ordinary resin, there are no gaps for the solvent to soak into, and therefore, such swelling does not occur and the film thickness does not become extremely thick after the reworking. Based on the above, the inventive composition forms a porous film that a solvent can soak into and the film density is low, and gas also soaks into and permeates the film in the same manner as the solvent.

Meanwhile, the inventive resist underlayer film can exhibit favorable processing resistance and excellent filling property and flatness, also can have low film density, and can exhibit favorable gas permeability.

Meanwhile, according to the inventive method for manufacturing a resist underlayer film, it is possible to manufacture a resist underlayer film that can exhibit favorable processing resistance and excellent filling property and flatness, can also have low film density, and can exhibit favorable gas permeability.

Meanwhile, according to the inventive patterning process, it is possible to eliminate rapidly bubbles generated when the mold is pressed into the curable composition film, and a fine pattern can be formed.

Meanwhile, according to the inventive methods for manufacturing a semiconductor device, it is possible to manufacture a semiconductor device in which a fine pattern is formed on a semiconductor substrate.

### DESCRIPTION OF EMBODIMENTS

As explained above, there have been demands for the development of a resist underlayer film having excellent processing resistance, filling property, and flatness, and also high gas permeability, for forming a resist underlayer film that allows a resist pattern to be transferred to a substrate to be processed with higher accuracy in a fine patterning process.

The present inventors have focused on aromatic ring-containing polymers, which have sufficient mechanical strength but form a dense film due to packing, considered the introduction of a structure that inhibits packing, and studied earnestly. As stated above, photo-nanoimprinting technology, according to which it is possible to form a fine structure on a substrate in the order of several nanometers, is attracting attention, but there is a problem that defects are generated due to bubbles that are generated when the mold is pressed on, and until now, improvement of the gas permeability and so forth of the mold has been carried out. On the other hand, the current improvement on the side of the mold alone is insufficient considering future miniaturization etc., and defoaming from the side of the resist underlayer film is being considered, but development of materials has not progressed, and there is still little choice of materials. The present inventors have considered that when an aromatic compound containing a phenolic hydroxy group as a core is subjected to polyetherification with a linear, branched, or cyclic hydrocarbon group or heteroalkylene group and an ether group as linkers, sufficient mechanical strength can be provided by virtue of the aromatic ring and flowability can be imparted and the packing of aromatic rings can be suppressed by virtue of the hydrocarbon group or heteroalkylene group and the ether group, which are linkers, and thus, it is possible to achieve a film having favorable filling property, favorable flatness, low film density, and also excellent gas permeability. The present inventors have further considered that by etherifying unreacted hydroxy groups, which did not react at the time of polyetherification, further improvement of flowability and suppression of packing are also possible, and that it is possible to achieve a composition for forming a resist underlayer film that can exhibit even better filling property, flatness, and gas permeability.

The present inventors have further studied earnestly on the basis of this idea and found out that a composition for forming a resist underlayer film containing (A) a polyether compound containing a repeating unit represented by the following general formula (I) and (B) an organic solvent can realize a resist underlayer film that has mechanical strength to withstand processing, is excellent in filling property and flatness, and has low film density and favorable gas permeability, and completed the present invention.

That is, the present invention is a composition for forming a resist underlayer film, comprising:
(A) a polyether compound containing a repeating unit represented by the following general formula (I); and
(B) an organic solvent, 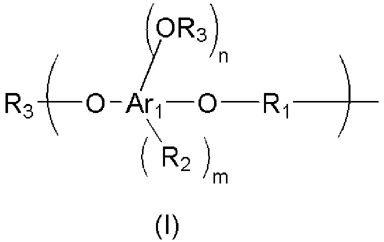
wherein Ar₁ represents a substituted or unsubstituted aryl group having 6 to 30 carbon atoms, a substituted or unsubstituted heteroaryl group having 6 to 30 carbon atoms, a substituted or unsubstituted aryl group having 6 to 30 carbon atoms fused or linked with an aliphatic ring or a heterocycle, or a plurality of substituted or unsubstituted aryl groups each having 6 to 30 carbon atoms and linked with each other via a linear, branched, or cyclic hydrocarbon group, an ether group, or a carbonyl group, Ar₁ being of one kind or a combination of two or more kinds within a single resin, R₁ represents a substituted or unsubstituted, linear, branched, or cyclic, saturated or unsaturated divalent hydrocarbon group having 1 to 20 carbon atoms or a substituted or unsubstituted, linear, branched, or cyclic heteroalkylene group having 1 to 20 carbon atoms, R₂ represents a substituted or unsubstituted, linear, branched, or cyclic, saturated or unsaturated hydrocarbon group having 1 to 20 carbon atoms, a substituted or unsubstituted heteroalkyl group having 1 to 20 carbon atoms, an amino group, a thiol group, or a halogen atom, R₃ is of one kind or a combination of two or more kinds within a single resin and represents a hydrogen atom, a substituted or unsubstituted, linear, branched, or cyclic alkyl group having 1 to 20 carbon atoms, a substituted or unsubstituted, linear, branched, or cyclic alkenyl group having 2 to 20 carbon atoms, or a substituted or unsubstituted, linear, branched, or cyclic alkynyl group having 2 to 20 carbon atoms, and "n" and "m" each represent an integer of 0 or more.

Hereinafter, the present invention will be described in detail, but the present invention is not limited thereto.

### <Composition for Forming Resist Underlayer Film>

The inventive composition for forming a resist underlayer film for nanoimprinting contains:
(A) a polyether compound containing a repeating unit represented by the following general formula (I); and
(B) an organic solvent.

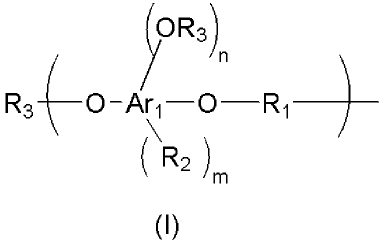

In the general formula (I), Ar₁ represents a substituted or unsubstituted aryl group having 6 to 30 carbon atoms, a substituted or unsubstituted heteroaryl group having 6 to 30 carbon atoms, a substituted or unsubstituted aryl group having 6 to 30 carbon atoms fused or linked with an aliphatic ring or a heterocycle, or a plurality of substituted or unsubstituted aryl groups each having 6 to 30 carbon atoms and linked with each other via a linear, branched, or cyclic hydrocarbon group, an ether group, or a carbonyl group, Ar₁ being of one kind or a combination of two or more kinds within a single resin, R₁ represents a substituted or unsubstituted, linear, branched, or cyclic, saturated or unsaturated divalent hydrocarbon group having 1 to 20 carbon atoms or a substituted or unsubstituted, linear, branched, or cyclic heteroalkylene group having 1 to 20 carbon atoms, R₂ represents a substituted or unsubstituted, linear, branched, or cyclic, saturated or unsaturated hydrocarbon group having 1 to 20 carbon atoms, a substituted or unsubstituted heteroalkyl group having 1 to 20 carbon atoms, an amino group, a thiol group, or a halogen atom, R₃ is of one kind or a combination of two or more kinds within a single resin and represents a hydrogen atom, a substituted or unsubstituted, linear, branched, or cyclic alkyl group having 1 to 20 carbon atoms, a substituted or unsubstituted, linear, branched, or cyclic alkenyl group having 2 to 20 carbon atoms, or a substituted or unsubstituted, linear, branched, or cyclic alkynyl group having 2 to 20 carbon atoms, and "n" and "m" each represent an integer of 0 or more.

The above-described polyether compound contains an aromatic ring in the Ar₁ in the polymer main chain, and therefore, has excellent mechanical strength (also referred to as processing resistance) for withstanding processing. Meanwhile, by polyetherifying the Ar₁, using the linear, branched, or cyclic hydrocarbon group or heteroalkylene group represented by R₁ and the ether group as linkers, it is possible to suppress close packing of aromatic rings and a dense crosslinking reaction, and suppress the densification of a film. By virtue of appropriately selection of the main skeleton structure and the substituent structure in this manner, it is possible to achieve both processing resistance and gas permeability, which are conflicting properties with each other. In addition, flowability can be provided by the R₁ and the ether group, which are linkers, and therefore, it is also possible to realize excellent filling property and excellent flatness. Therefore, according to the present invention, it is possible to provide a resist underlayer film which can have excellent hardness and can exhibit mechanical strength to withstand processing (has excellent processing resistance), can have excellent filling property and flatness, and can also have low film density and can be expected to exhibit excellent gas permeability.

Furthermore, by introducing multiple substituents, such as R₂ and R₃, thermal flowability can also be imparted. In addition, the steric hindrance of the optional substituent R₂ or the optional substituent containing the R₃ introduced via an ether structure makes it possible further to suppress close packing of aromatic rings and a dense crosslinking reaction, and further suppress the densification of a film.

According to the inventive composition for forming a resist underlayer film, it is possible to form a resist underlayer film usable in various patterning processes. For example, a resist underlayer film formed from the inventive composition for forming a resist underlayer film can be used as a resist underlayer film in a patterning process according to a multilayer resist process, can be used as a resist underlayer film in a patterning process according to a nanoimprinting method, and can also be used in other patterning processes. In particular, as described earlier, a resist underlayer film formed from the inventive composition for forming a resist underlayer film has favorable processing resistance, has excellent filling property and flatness, also has low film density, and can exhibit favorable gas permeability. Therefore, the inventive composition for forming a resist underlayer film can realize a resist underlayer film that is very useful in nanoimprinting.

In the following, each component of the inventive composition for forming a resist underlayer film will be described in more detail.

### <(A) Polyether Compound>

In the general formula (I), Ar₁ represents a substituted or unsubstituted aryl group having 6 to 30 carbon atoms, a substituted or unsubstituted heteroaryl group having 6 to 30 carbon atoms, a substituted or unsubstituted aryl group having 6 to 30 carbon atoms fused or linked with an aliphatic ring or a heterocycle, or a plurality of substituted or unsubstituted aryl groups each having 6 to 30 carbon atoms and linked with each other via a linear, branched, or cyclic hydrocarbon group, an ether group, or a carbonyl group, Ar₁ being of one kind or a combination of two or more kinds within a single resin. From the viewpoint of enhancing the strength against processing, as the Ar₁, naphthalene is preferable to benzene and anthracene is preferable to naphthalene, and from the viewpoint of gas permeability, the Ar₁ is preferably a group in which multiple benzene rings and/or naphthalene rings are linked or fused with each other via a linear, branched, or cyclic alkylene group or ether group.

In the general formula (I), R₂ is optional, and represents a substituted or unsubstituted, linear, branched, or cyclic, saturated or unsaturated hydrocarbon group having 1 to 20 carbon atoms, a substituted or unsubstituted heteroalkyl group having 1 to 20 carbon atoms, an amino group, a thiol group, or a halogen atom. From the viewpoint of suppressing packing, R₂ is preferably a hydrocarbon group, and to maintain processing resistance as well, R₂ is more preferably a cyclic hydrocarbon group. Furthermore, from the viewpoint of enhancing the hydrophobicity of the film, R₂ is preferably a halogen atom, particularly preferably a fluorine atom.

Examples of specific structures of the Ar₁, including the R₂, in the general formula (I) include the following structures, but are not limited thereto. "*" represents an attachment point to the oxygen atom in the polymer main chain or an attachment point to the oxygen atom of the optional substituent OR₃.

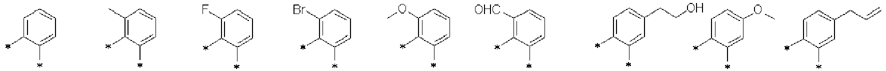

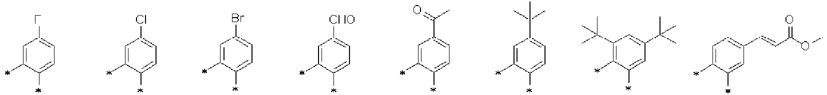

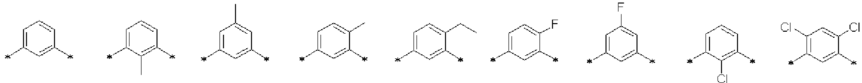

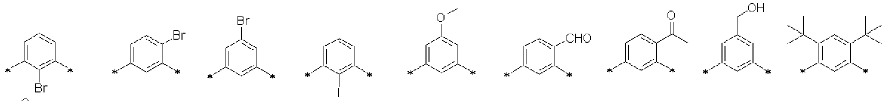

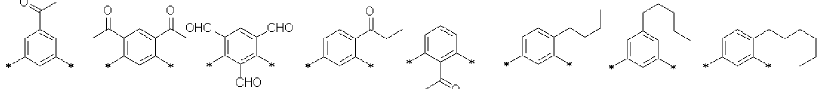

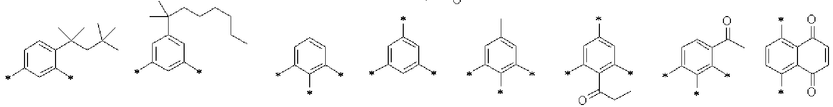

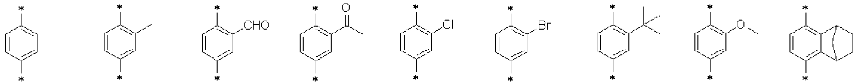

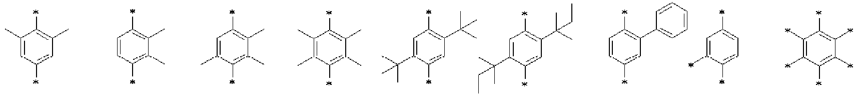

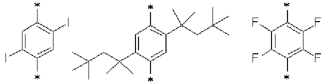

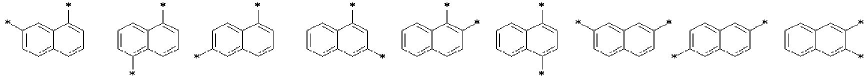

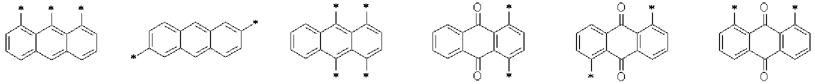

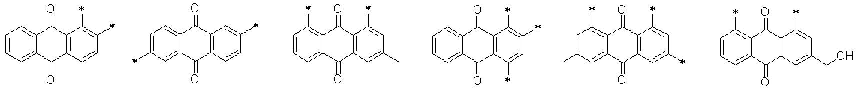

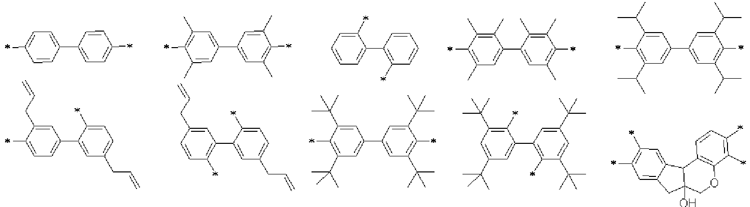

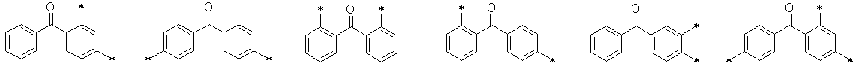

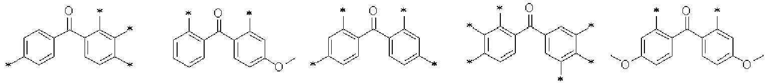

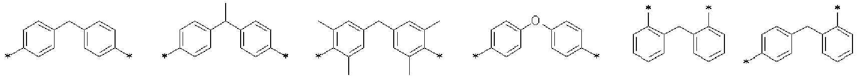

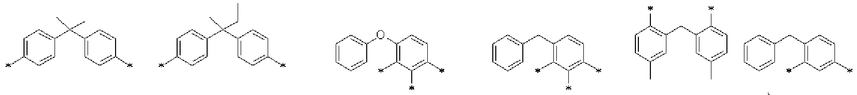

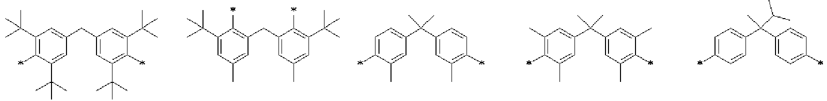

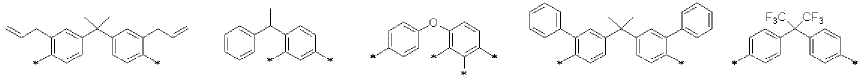

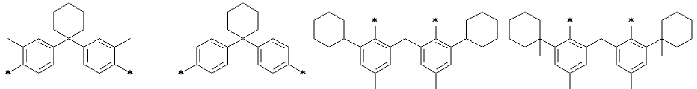

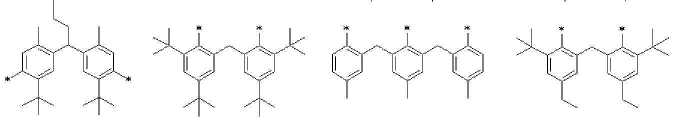

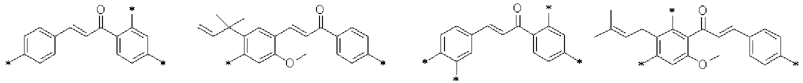

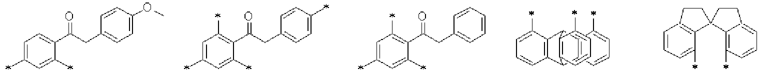

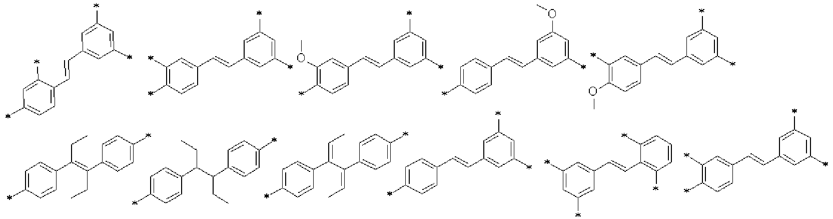

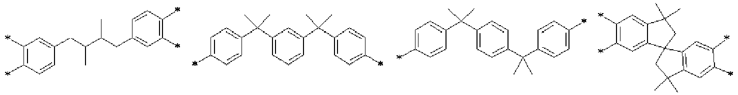

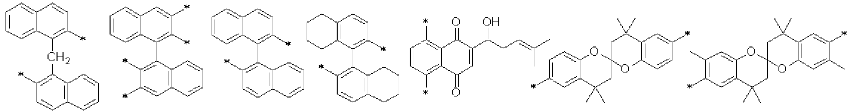

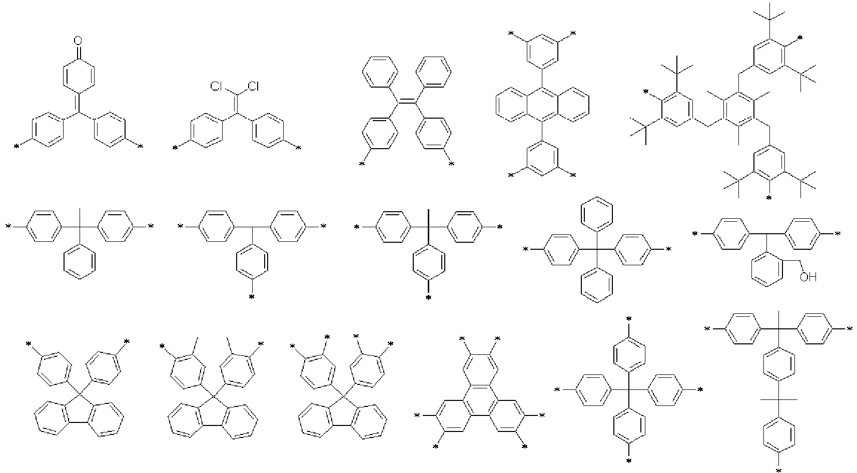

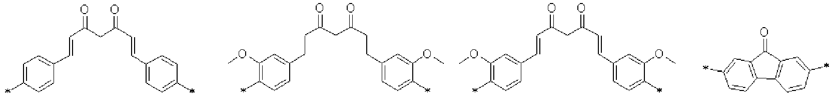

In the general formula (I), R₁ represents a substituted or unsubstituted, linear, branched, or cyclic, saturated or unsaturated divalent hydrocarbon group having 1 to 20 carbon atoms or a substituted or unsubstituted, linear, branched, or cyclic heteroalkylene group having 1 to 20 carbon atoms. From the viewpoints of suppressing the packing of aromatic rings and maintaining processing resistance, R₁ is preferably a cyclic hydrocarbon group or heteroalkyl group. Furthermore, from the viewpoint of thermosetting property, R₁ preferably contains an unsaturated bond. Furthermore, a combination of multiple R₁s may also be contained in a single resin. When multiple R₁s are combined, improvement of solubility and improvement of thermal flowability can be expected.

Examples of specific structures of the R₁ in the general formula (I) include the following structures, but are not limited thereto. "*" represents an attachment point to the oxygen atom.

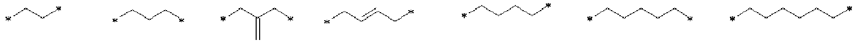

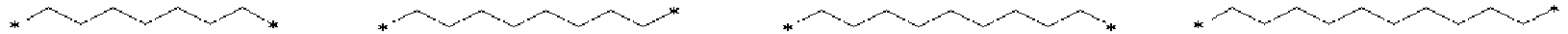

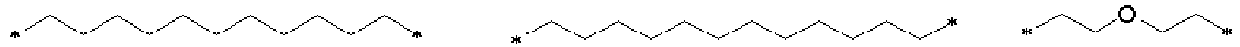

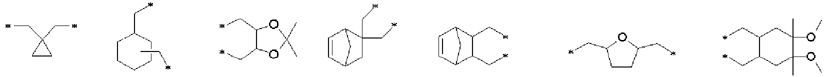

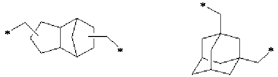

In the general formula (I), it is particularly preferable that the R₁ is selected from the group consisting of the groups represented by the following general formulae (III-1) to (III-3).

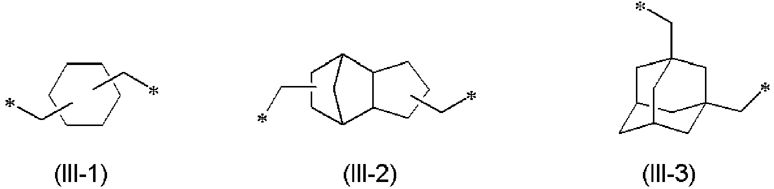

In the formulae (III-1) to (III-3), "*" represents an attachment point to the oxygen atom.

When the R₁ in the general formula (I) is selected from the group consisting of the groups represented by the general formulae (III-1) to (III-3), processing resistance is hardly degraded since the polyether compound has a cyclic structure, and on the other hand, the cyclic structure itself has low density and also has great steric hindrance, and therefore, the compound has a high effect of preventing aromatic rings from adjoining each other densely and a film having low film density can be achieved. That is, the composition in this preferable aspect can provide a resist underlayer film that exhibits better processing resistance and higher gas permeability.

In the general formula (I), R₃ is of one kind or a combination of two or more kinds within a single resin and represents a hydrogen atom, a substituted or unsubstituted, linear, branched, or cyclic alkyl group having 1 to 20 carbon atoms, a substituted or unsubstituted, linear, branched, or cyclic alkenyl group having 2 to 20 carbon atoms, or a substituted or unsubstituted, linear, branched, or cyclic alkynyl group having 2 to 20 carbon atoms. From the viewpoint of thermosetting property, R₃ is preferably an alkenyl group or an alkynyl group. Meanwhile, from the viewpoint of suppressing the packing of aromatic rings, R₃ is preferably a branched or cyclic alkyl group, and to include the viewpoint of maintaining processing resistance, R₃ is more preferably a cyclic alkyl group.

Examples of specific structures of the R₃ in the general formula (I) include the following structures, but are not limited thereto. "*" represents an attachment point to the oxygen atom.

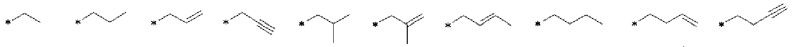

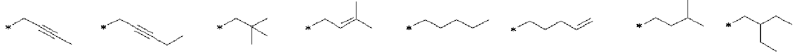

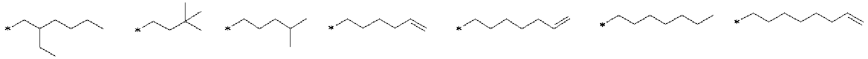

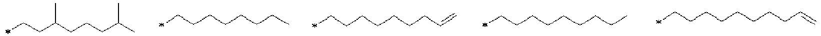

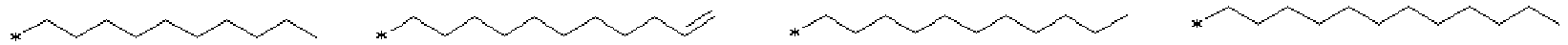

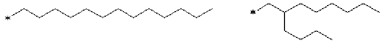

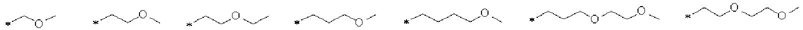

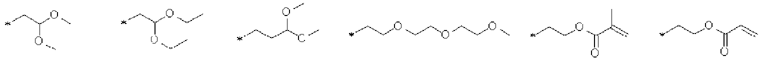

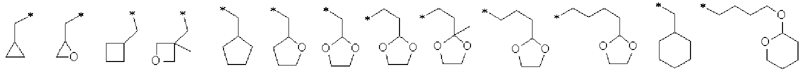

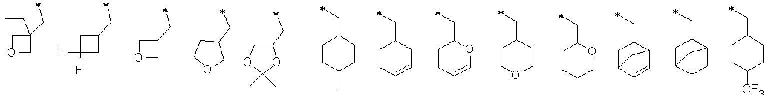

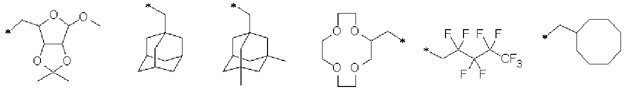

It is preferable that at least one of the R₃ in the general formula (I) is a structure R_{II-1} selected from the group consisting of groups represented by the following formulae (II-1), and a proportion "a" of the structure R_{II-1} is 1 ≤ a ≤ 100.

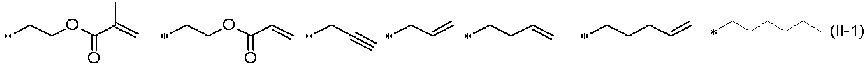

In the formulae (II-1), "*" represents an attachment point to the oxygen atom.

When at least one of the R₃ in the general formula (I) is a structure R_{II-1} selected from the group consisting of groups represented by the general formulae (II-1), the steric hindrance of the structure makes it possible to suppress further the packing of aromatic rings, and prevent further the densification of a film. In addition, by end-capping a hydroxy group, hydrophobicity can be enhanced, so that it is possible to enhance affinity to hydrophobic gases, such as He and N₂, and improve the permeability of these gases. Furthermore, out of the structures R_{II-1}, those which contain an unsaturated bond make it possible to impart crosslinking property to the compound itself. Therefore, when the R₃ which has the structure R_{II-1} containing an unsaturated bond is contained, it is possible to provide a resist underlayer film that can undergo self-crosslinking, has low film density, and furthermore, is hydrophobic.

It is also preferable that the R₃ in the general formula (I) is a combination of a structure R_{II-1} selected from the group consisting of groups represented by the following formulae (II-1) and a structure R_{II-2} selected from the group consisting of groups represented by the following formulae (II-2), and a proportion "a" of the structure R_{II-1} and a proportion "b" of the structure R_{II-2} satisfy relationships 1 ≤ a ≤ 99, 1 ≤ b ≤ 99, and a + b = 100.

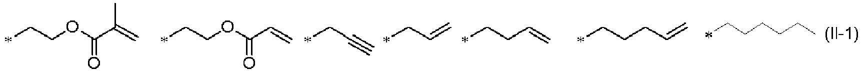

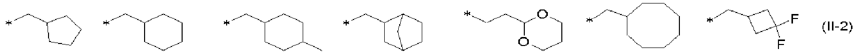

In the formulae (II-1) and (II-2), "*" represents an attachment point to the oxygen atom.

When at least one of the R₃ in the general formula (I) has a structure R_{II-2} selected from the group consisting of groups represented by the general formulae (II-2), there is little risk of processing resistance being degraded since the polyether compound has a cyclic structure, and on the other hand, the cyclic structure itself has low density and also has great steric hindrance, and therefore, the compound has a high effect of preventing aromatic rings from adjoining each other densely and a film having low film density can be achieved. In addition, when at least one of the R₃ has the structure R_{II-1} selected from the group consisting of the groups represented by the general formulae (II-1) containing an unsaturated bond, a self-crosslinkable film can be achieved. Furthermore, by end-capping the hydroxy group of the R₃ with the structures, the polarity of the compound can be reduced, and it is possible to improve the permeability of gases, such as He, H₂, N₂, and air, which are hydrophobic. Furthermore, when R₃ is a combination of multiple substituents, it is possible to reduce the crystallinity of the resin and also enhance thermal flowability. That is, when such a compound is contained in a composition, it is possible to provide a resist underlayer film that has low film density and exhibits excellent gas permeability, and is also excellent in processing resistance, filling property, and flatness.

From the viewpoint of thermosetting property, the R₃ in the general formula (I) is preferably a structure R_{II-1} selected from the group consisting of the groups represented by the general formulae (II-1) and containing an unsaturated bond, and from the viewpoints of maintaining processing resistance, reducing film density, and enhancing thermal flowability, the R₃ is preferably a structure R_{II-2} selected from the group consisting of the groups represented by the general formulae (II-2). Therefore, when R₃s include the structure R_{II-1} at a proportion to guarantee the curing property of the composition, the other R₃s are preferably structures R_{II-2} selected from the group consisting of the groups represented by the general formulae (II-2). In other words, the proportions at which the combination of structures selected from the structures R_{II-1} and the structures R_{II-2} is contained are more preferably proportions at which curability can be ensured by the resin alone at the very least, and specifically, the proportions preferably satisfy the relationships 1 ≤ a ≤ 99, 1 ≤ b ≤ 99, and a + b = 100, more preferably satisfy the relationships 30 ≤ a ≤ 90 and a + b = 100, and particularly preferably satisfy the relationships 50 ≤ a ≤ 80 and a + b = 100.

In the general formula (I), "n" and "m" each represent an integer of 0 or more. From the viewpoint of providing thermosetting property and steric hindrance by an ether structure, "n" is preferably 1 or 2. "m" is preferably 0 or more and 4 or less. "m" is also more preferably 2 or more for the same reasons as the "n", but from the viewpoint of the availability of starting materials, "m" may be 0.

For example, the Ar₁ in the general formula (I) is preferably selected from the group consisting of structures represented by the following formulae (Ar-1).

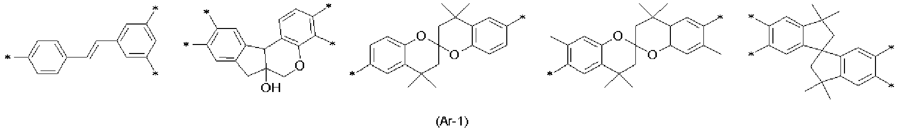

In the formulae (Ar-1), "*" represents an attachment point to the oxygen atom of the -O-R₁- or OR₃.

Every structure represented by the formulae (Ar-1) has two benzene rings within a single structure, and therefore, can be expected to exhibit excellent processing resistance. Furthermore, when the rings are bonded or fused with each other via a linear, branched, or cyclic alkylene chain or an ether chain, the structure can suppress the packing of aromatic rings with each other, for example, by having a spiro structure having a three-dimensionally distorted structure, and it is possible to suppress the densification of the film after baking. Therefore, the composition in this preferable aspect makes it possible to provide a resist underlayer film that has low film density after baking and exhibits better gas permeability.

When the Ar₁ within a single resin of the polyether compound (A) is a combination of multiple kinds, the polyether compound (A) can also contain multiple repeating units having different Ar₁s within a single resin. Similarly, when the R₃ within a single resin of the polyether compound (A) is a combination of multiple kinds, the polyether compound (A) can also contain multiple repeating units having different R₃s within a single resin.

### <Synthesis Method>

The polyether compound (A) can be synthesized by, for example, performing a polyetherification reaction (STEP 1) by using an Ar₁-derivative (X) containing a hydroxy group, a reagent X-R₁-X (Y), being an alkyl dihalide, alkyl ditosylate, or alkyl dimesylate, and a catalyst, and then performing etherification (STEP 2) by using the polymer obtained by the polyetherification, a reagent R₃-X (Z), being an alkyl halide, alkyl tosylate, or alkyl mesylate, and a catalyst. R₁, R₂, R₃, "n", and "m" are as defined above, and X represents a halogen group, a mesyl group, or a tosyl group. Two or more kinds of R₃-X are used in some cases, but for the convenience of this explanation, only one kind is shown.

### (STEP 1)

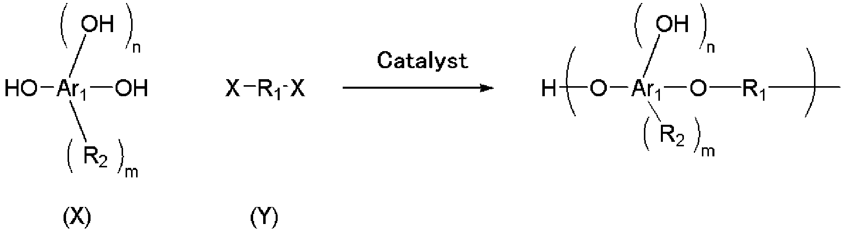

### (STEP 2)

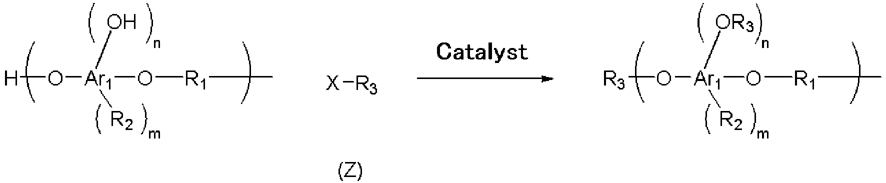

The amount of the reagent (Y) to be used in the above-described STEP 1 is preferably 0.6 to 0.95 equivalents, more preferably 0.7 to 0.9 equivalents relative to the derivative (X). When the amount of the reagent (Y) used is within the preferable range, the hydroxy groups that were not consumed in the polyetherification partly remain after STEP 1 is completed. For example, to consider a case where 1 equivalent of resorcinol (2 equivalents of hydroxy groups) as the derivative (X) and 0.9 equivalents of dibromobutane (1.8 equivalents of reaction points with hydroxy groups) as the reagent (Y) are allowed to react as in the following formula, 0.2 equivalents of the hydroxy groups that are not consumed in the polyetherification remain. Meanwhile, to consider a case where 1 equivalent of phloroglucinol (3 equivalents of hydroxy groups) as the derivative (X) and 0.9 equivalents of dibromohexane (1.8 equivalents of reaction points with hydroxy groups) as the reagent (Y) are allowed to react, 1.2 equivalents of the hydroxy groups that are not consumed in the polyetherification remain. In particular, in the example using phloroglucinol, a case where one hydroxy group is not involved in the polyetherification is shown for the convenience of explanation, but in reality, there is a case where the hydroxy group is not involved in the polyetherification, a case where only one hydroxy group is involved in the polyetherification, and a case where all three hydroxy groups are involved in the polyetherification. The residue of these hydroxy groups can be etherified by the STEP 2. In the case with resorcinol, a reaction example where propargyl bromide is used as the reagent (Z) is shown, and in the case with phloroglucinol, a reaction example where propargyl bromide and bromohexane are used as the reagent (Z) is shown.

### (STEP 1 in Case of Resorcinol)

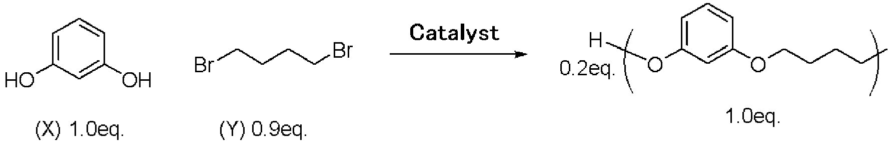

### (STEP 1 in Case of Phloroglucinol)

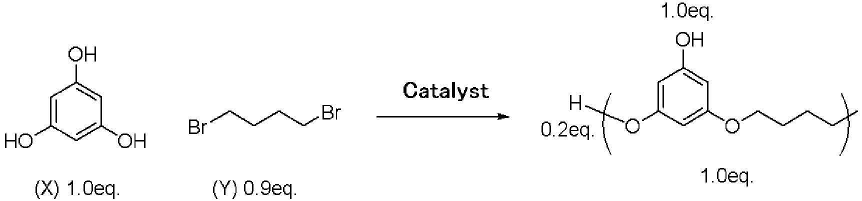

### (STEP 2 in Case of Resorcinol)

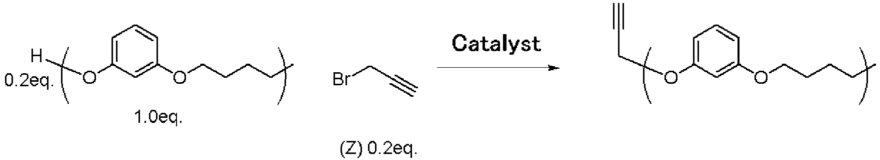

### (STEP 2 in Case of Phloroglucinol)

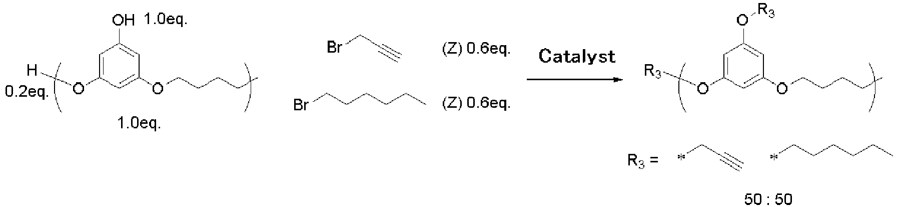

The above-described polyetherification reaction using a derivative (X), a reagent (Y), and a catalyst can usually be performed without a solvent or in a solvent and using a base as a catalyst at room temperature or, as necessary, under cooling or heating. Examples of the solvent used in STEP 1 include: alcohols, such as methanol, ethanol, isopropyl alcohol, butanol, ethylene glycol, propylene glycol, diethylene glycol, glycerol, methyl cellosolve, ethyl cellosolve, butyl cellosolve, and propylene glycol monomethyl ether; ethers, such as diethyl ether, dibutyl ether, diethylene glycol diethyl ether, diethylene glycol dimethyl ether, tetrahydrofuran, and 1,4-dioxane; chlorine-based solvents, such as methylene chloride, chloroform, dichloroethane, and trichloroethylene; hydrocarbons, such as hexane, heptane, benzene, toluene, xylene, and cumene; nitriles, such as acetonitrile; ketones, such as acetone, ethyl methyl ketone, and isobutyl methyl ketone; esters, such as ethyl acetate, n-butyl acetate, and propylene glycol methyl ether acetate; lactones, such as γ-butyrolactone; and aprotic polar solvents, such as dimethyl sulfoxide, N,N-dimethylformamide, hexamethylphosphoric triamide, and N-methylpyrrolidone. One of these solvents may be used, or two or more kinds thereof may be used in mixture. These solvents can be used in an amount of, for example, 0 to 3000 parts by mass based on 100 parts by mass of the reaction raw materials.

Examples of base catalysts that can be used in STEP 1 include: inorganic bases, such as sodium hydroxide, potassium hydroxide, barium hydroxide, sodium carbonate, sodium hydrogencarbonate, potassium carbonate, lithium hydride, sodium hydride, potassium hydride, and calcium hydride; alkyl metals, such as methyllithium, n-butyllithium, methylmagnesium chloride, and ethylmagnesium bromide; alkoxides, such as sodium methoxide, sodium ethoxide, and potassium t-butoxide; and organic bases, such as triethylamine, diisopropylethylamine, N,N-dimethylaniline, pyridine, and 4-dimethylaminopyridine. The amount of the catalyst to be used is, for example, 0.1 to 1.5 equivalents, preferably 1.0 to 1.05 equivalents based on the amount of the hydroxy groups in the raw materials. The reaction temperature is preferably -50°C to approximately the boiling point of the solvent, further preferably room temperature to 130°C.

Examples of the polyetherification reaction (STEP 1) include: a method in which a derivative (X), a reagent (Y), and a catalyst are charged at once; a method in which a reagent (Y) or a solution obtained by dissolving the reagent (Y) in a reaction solvent is dropped in in the presence of a derivative (X) and a catalyst; and a method in which a derivative (X) or a solution obtained by dissolving the derivative (X) in a reaction solvent is dropped in in the presence of a reagent (Y) and a catalyst. After the polyetherification reaction is completed, the reagent (Z) or a solution obtained by dissolving the reagent (Z) in a reaction solvent may be added dropwise to perform the etherification of STEP 2 continuously, or alternatively, to remove unreacted raw materials, the catalyst, etc. present in the system, one of the following methods may be used depending on the used raw materials and the amount and properties of the obtained reaction product: a method of raising the temperature of the reaction vessel to 130 to 230°C to remove the volatile content at about 1 to 50 mmHg; a method of adding an appropriate poor solvent or water and precipitating the polymer; a method of fractionating the polymer; etc. It is also possible to add a step of dissolving the obtained polyether compound in an appropriate solvent, such as methyl isobutyl ketone and ethyl acetate, and washing the product with water.

The etherification (STEP 2) after the polyetherification can also be performed, for example, without a solvent or in a solvent and using a base as a catalyst at room temperature or under cooling or heating as necessary. Examples of the solvent used in STEP 2 include: alcohols, such as methanol, ethanol, isopropyl alcohol, butanol, ethylene glycol, propylene glycol, diethylene glycol, glycerol, methyl cellosolve, ethyl cellosolve, butyl cellosolve, and propylene glycol monomethyl ether; ethers, such as diethyl ether, dibutyl ether, diethylene glycol diethyl ether, diethylene glycol dimethyl ether, tetrahydrofuran, and 1,4-dioxane; chlorine-based solvents, such as methylene chloride, chloroform, dichloroethane, and trichloroethylene; hydrocarbons, such as hexane, heptane, benzene, toluene, xylene, and cumene; nitriles, such as acetonitrile; ketones, such as acetone, ethyl methyl ketone, and isobutyl methyl ketone; esters, such as ethyl acetate, n-butyl acetate, and propylene glycol methyl ether acetate; lactones, such as γ-butyrolactone; and aprotic polar solvents, such as dimethyl sulfoxide, N,N-dimethylformamide, hexamethylphosphoric triamide, and N-methylpyrrolidone. One of these solvents may be used, or two or more kinds thereof may be used in mixture. These solvents can be used in an amount of 0 to 2,000 parts by mass based on 100 parts by mass of the reaction raw materials.

Examples of base catalysts that can be used in STEP 2 include: inorganic bases, such as sodium hydroxide, potassium hydroxide, barium hydroxide, sodium carbonate, sodium hydrogencarbonate, potassium carbonate, lithium hydride, sodium hydride, potassium hydride, and calcium hydride; alkyl metals, such as methyllithium, n-butyllithium, methylmagnesium chloride, and ethylmagnesium bromide; alkoxides, such as sodium methoxide, sodium ethoxide, and potassium t-butoxide; and organic bases, such as triethylamine, diisopropylethylamine, N,N-dimethylaniline, pyridine, and 4-dimethylaminopyridine. The amount of the catalyst to be used is preferably 0.1 to 1.5 equivalents, more preferably 1.0 to 1.2 equivalents based on the amount of the hydroxy groups contained in the raw materials. The reaction temperature is preferably -50°C to approximately the boiling point of the solvent, further preferably room temperature to 130°C.

Examples of the reaction method include: a method in which the above-described polyether compound, a reagent (Z), and a catalyst are charged at once; a method in which a reagent (Z) or a solution obtained by dissolving the reagent (Z) in a reaction solvent is dropped in in the presence of the polyether compound and a catalyst; and a method in which a solution obtained by dissolving the polyether compound in a reaction solvent is dropped in in the presence of a reagent (Z) and a catalyst. In this event, the amount of the reagent (Z) to be used is preferably 1.0 to 1.2 equivalents, more preferably 1.0 to 1.05 equivalents based on the amount of the hydroxy residue of the polyether compound. In addition, when multiple kinds of the reagent (Z) are used, it is possible to select a method from the following: a method in which a reagent (Z), having greater steric hindrance in the reaction moiety and having lower reactivity like bromomethylcyclohexane etc., is dropped in first and aged, and then a reagent (Z), having a lower steric hindrance in the reaction site and having higher reactivity like propargyl bromide, is added afterwards; and a method in which a reagent (Z) having a higher boiling point, such as a mesyl compound or a tosyl compound, which cannot be removed after the reaction under reduced pressure, is dropped in first and aged, and then a small excess of a reagent (Z) having a lower boiling point, such as propargyl bromide and bromopropene, which are removable after the reaction under reduced pressure, is dropped in afterwards to increase the substitution rate. After the etherification is completed, to remove unreacted raw materials, the catalyst, etc. present in the system, one of the following treatments may be performed depending on the properties of the used raw materials or the obtained reaction product: a method of raising the temperature of the reaction vessel to 130 to 230°C to remove the volatile content at about 1 to 50 mmHg; a method of adding an appropriate poor solvent or water and precipitating the polymer; a method of fractionating the polymer; etc. In the end, it is also possible to add steps of dissolving the obtained polyether compound (A) in an appropriate solvent, such as methyl isobutyl ketone and ethyl acetate, performing acid washing by using an aqueous solution containing an appropriate acid, such as nitric acid and hydrochloric acid, and then washing with ultrapure water to remove metal species such as sodium and potassium.

Furthermore, the polyether compound (A) obtained by a synthesis method described above preferably has a weight-average molecular weight Mw of 2000 to 12000, more preferably 2000 to 8000 as measured by gel permeation chromatography in terms of polystyrene from the viewpoints of filling property and also suppression of sublimation products.

When the polyether compound (A) has a weight-average molecular weight Mw of 2000 to 12000, it is possible to achieve an underlayer film in which low-molecular-weight components to become sublimation products at the time of baking are reduced and has no risk of filling property being degraded. When the Mw is 2000 to 8000, these advantageous effects are enhanced further.

### <(B) Organic Solvent>

The organic solvent (B) usable is not particularly limited as long as it is capable of dissolving the above-described polyether compound (A) and, when contained, (C) a surfactant, (D) a crosslinking agent, (E) a thermally decomposable resin, (F) an acid generator, other additives, etc., described later.

Specifically, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The amount of the organic solvent to be contained is preferably 200 to 10,000 parts, more preferably 250 to 5,000 parts based on 100 parts by mass of the polyether compound (A).

Furthermore, in the inventive composition for forming a resist underlayer film, the organic solvent (B) may be a mixture of one or more kinds of organic solvent having a boiling point of lower than 180°C (low-boiling-point solvent (B1)) and one or more kinds of organic solvent having a boiling point of 180°C or higher (high-boiling-point solvent (B2)).

The high-boiling-point solvent is not particularly limited to hydrocarbons, alcohols, ketones, esters, ethers, or chlorine-based solvents as long as the solvent is capable of dissolving the components of the inventive composition for forming a resist underlayer film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used as the high-boiling-point solvent (B2).

The high-boiling-point solvent may be selected suitably from the solvents above, for example, depending on the temperature at which the inventive composition for forming a resist underlayer film is heat-treated, etc. The boiling point of the high-boiling-point solvent is preferably 180°C to 300°C, further preferably 200°C to 300°C. When the boiling point is as described, sufficient thermal flowability can be achieved at the time of film formation, since there is no risk of excessive evaporation rate at the baking (heating). Therefore, it is assumed that a resist underlayer film excellent in filling and planarizing properties can be formed. Moreover, a solvent having such a boiling point does not remain in the film without evaporating even after the baking. Therefore, there is no risk of the solvent adversely affecting the physical properties, such as filling property, of the film.

When the high-boiling-point solvent is used, the amount to be used is preferably 1 to 30 parts by mass per 100 parts by mass of the organic solvent having a boiling point lower than 180°C. When the contained amount is as described, sufficient thermal flowability can be imparted at the time of baking, and the solvent does not remain in the film and lead to degradation of physical properties, such as filling property, of the film. Therefore, such an amount is preferable.

### <Optional Components>

The inventive composition for forming a resist underlayer film can further contain optional components besides the above-described polyether compound (A) and the above-described organic solvent (B). In the following, optional components will be described.

### <(C) Surfactant>

The inventive composition may contain a surfactant (C). A surfactant (C) can be contained in the inventive composition for forming a resist underlayer film in order to improve coating property in spin-coating. Examples of the surfactant include those disclosed in [0142] to [0147] of JP2009-269953A. When the surfactant is contained, the contained amount is preferably 0.01 to 10 parts, more preferably 0.05 to 5 parts per 100 parts by mass of the polyether compound (A).

### [(D) Crosslinking Agent]

The inventive composition for forming a resist underlayer film may contain a crosslinking agent (D).

The crosslinking agent (D) promotes crosslinking in a film, and has a structure containing an aromatic ring, and therefore, adjoins the polyether compound (A) closely and has an effect of enhancing the density of the film. Therefore, there are few holes to be impregnated with the solvent, and swelling of the film after reworking is suppressed. Therefore, the crosslinking agent can be contained as a crosslinking promoting agent, a processing resistance improver, and also as a film-swelling inhibitor.

The crosslinking agent (D) is not particularly limited, and various known crosslinking agents can be widely used. Examples thereof include melamine-based crosslinking agents, acrylate-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol or alkoxymethyl-based crosslinking agents). The amount of the crosslinking agent (D) contained is preferably 5 to 50 parts by mass, more preferably 10 to 40 parts by mass per 100 parts by mass of the polyether compound (A).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agents include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1). 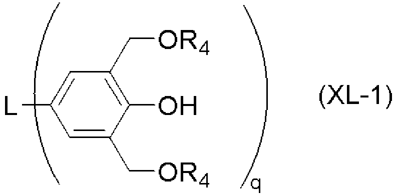 In the formula, L represents a single bond or a q-valent hydrocarbon group having 1 to 20 carbon atoms. R₄ represents a hydrogen atom or an alkyl group having 1 to 20 carbon atoms. "q" represents an integer of 1 to 5.

L represents a single bond or a hydrocarbon group having a valency of "q" and having 1 to 20 carbon atoms. "q" represents an integer of 1 to 5, more preferably 2 or 3. Specific examples of L include groups each of which is obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or eicosane. R₄ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

Specific examples of the compound represented by the general formula (XL-1) include the following compounds. In particular, from the viewpoints of enhancing the curability and film thickness uniformity of the organic film, hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene are particularly preferable. R₄ is as defined above.

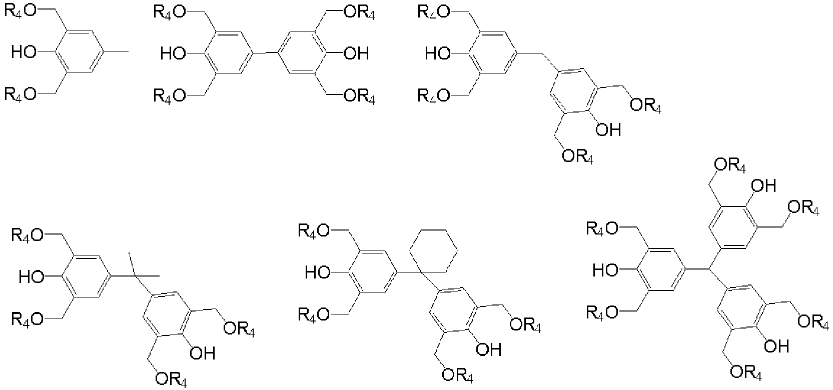

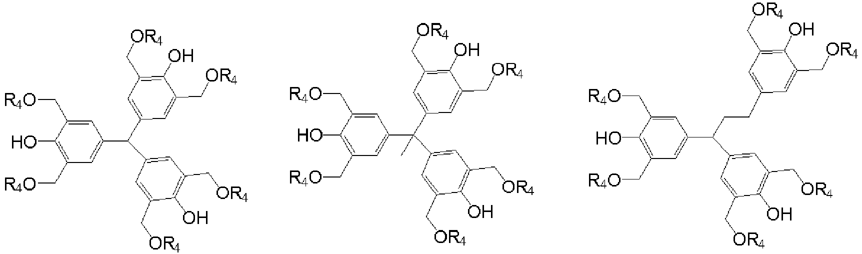

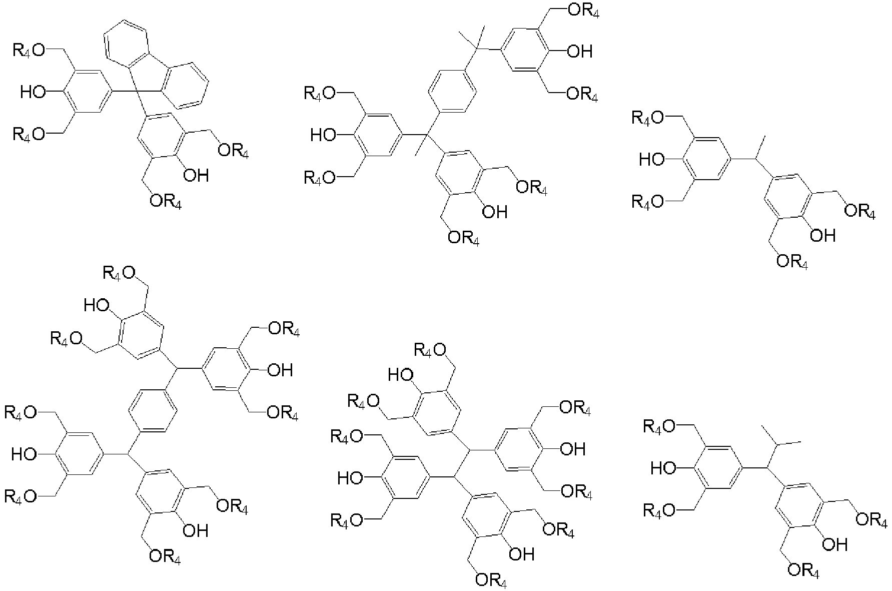

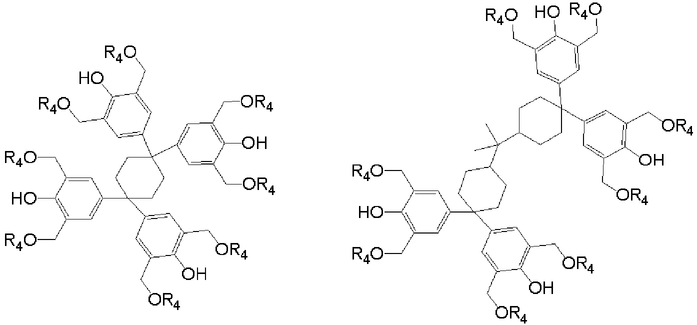

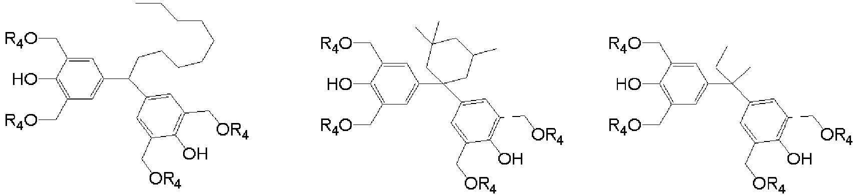

### <(E) Thermally Decomposable Resin>

The inventive composition for forming a resist underlayer film may further contain a thermally decomposable resin (E) from the viewpoint of reducing film density. When the thermally decomposable resin (E) is contained, the thermally decomposable resin is decomposed at the time of baking and sublimates from within the film, and thus, fine pores can be formed inside the film. Therefore, the film swells greatly after reworking the film, and it is possible to enhance the porosity of the film.

As the thermally decomposable resin (E), it is preferable to use a liquid additive having, for example, a polyethylene glycol or polypropylene glycol structure, or a thermo-decomposable polymer (resin) having a weight reduction rate of 40% by mass or more on heating from 30°C to 250°C and a weight-average molecular weight of 300 to 200,000. This thermo-decomposable polymer preferably contains a repeating unit having an acetal structure represented by any of the following general formulae (DP1) and (DP1a) to (DP3a). 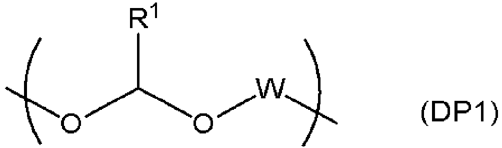 In the formula, R¹ represents a hydrogen atom or a saturated or unsaturated monovalent organic group having 1 to 30 carbon atoms, the organic group optionally being substituted. W represents a saturated or unsaturated divalent organic group having 2 to 30 carbon atoms. 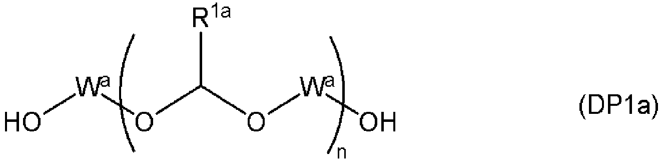 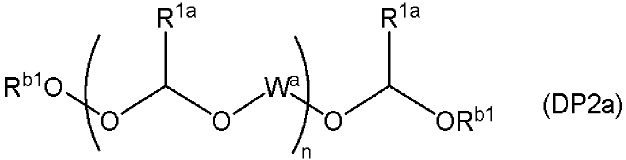 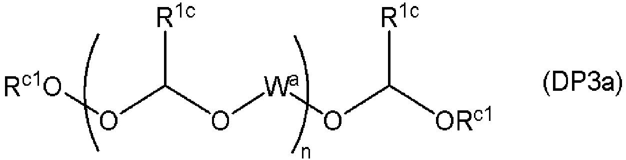 In the formulae (DP1a) to (DP3a), R^{1a} represents an alkyl group having 1 to 4 carbon atoms. W^{a} represents a saturated or unsaturated divalent hydrocarbon group having 4 to 10 carbon atoms and optionally having an ether bond. Each R^{b1} independently represents -W^{a}-OH or a saturated or unsaturated monovalent organic group having 1 to 30 carbon atoms, the organic group optionally being substituted. R^{1c} represents a hydrogen atom, an aryl group having 6 to 20 carbon atoms, or a heteroaryl group having 4 to 20 carbon atoms, the aryl group and the heteroaryl group optionally being substituted. Each R^{c1} independently represents an alkyl group having 1 to 4 carbon atoms or -W^{a}-OH. "n" represents an average repeating unit number of 3 to 500.

Specific examples of the thermally decomposable resin include the following, but are not limited thereto.

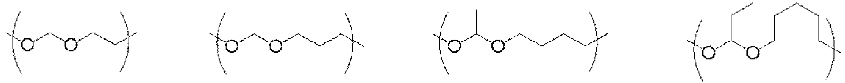

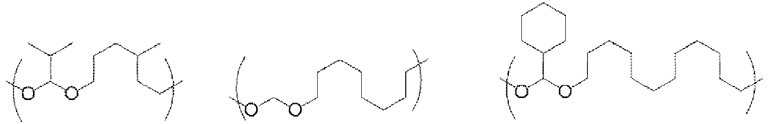

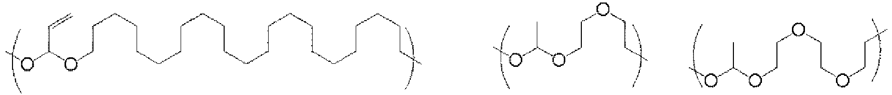

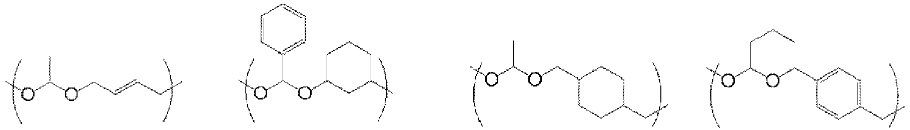

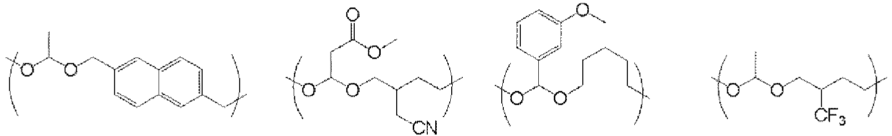

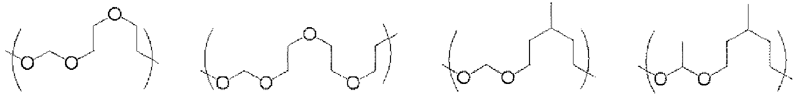

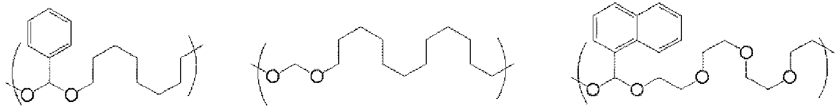

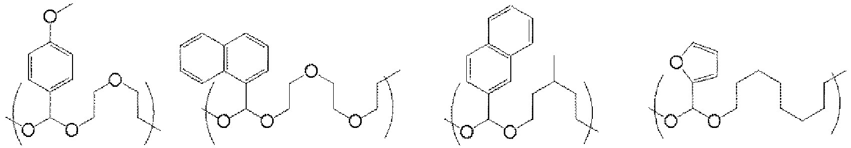

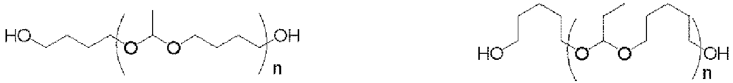

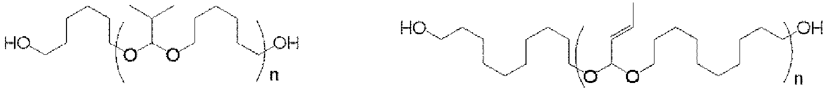

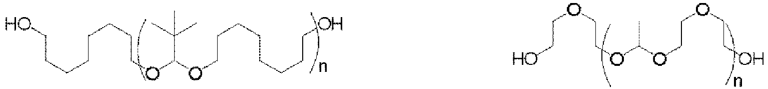

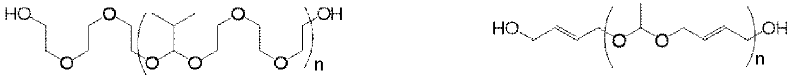

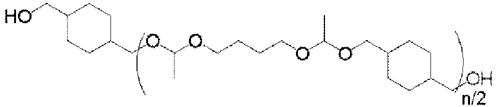

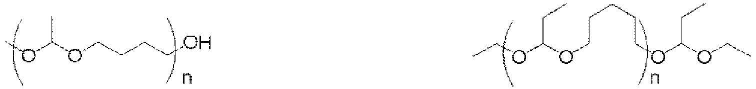

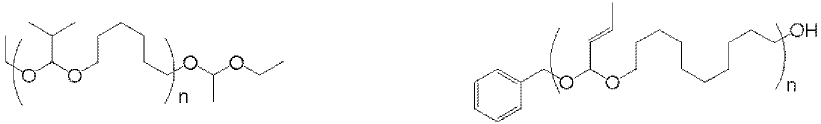

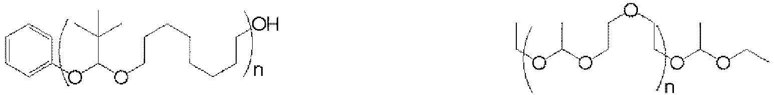

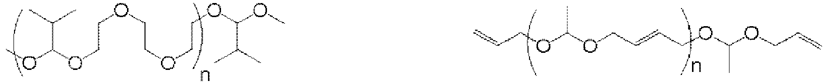

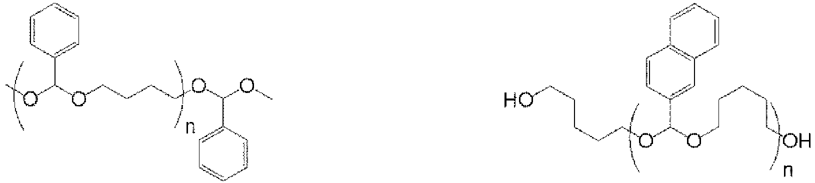

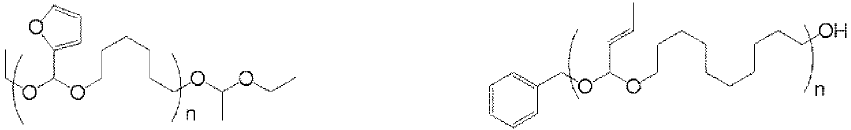

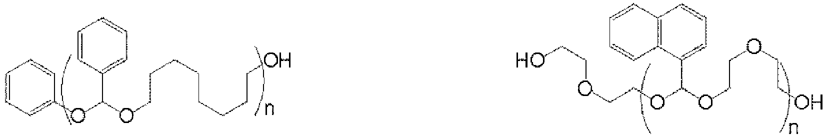

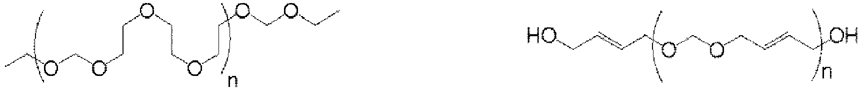

"n" represents an average repeating unit number of 3 or more and 500 or less.

When the thermally decomposable resin (E) is contained, the contained amount is preferably 0.05 to 50 parts, more preferably 0.1 to 10 parts per 100 parts by mass of the polyether compound (A).

### <(F) Acid Generator>

An acid generator can be contained in the inventive composition for forming a resist underlayer film in order to promote further the curing reaction of the polyether compound (A). Acid generators can be classified into those that generate an acid by thermal decomposition (thermal acid generators) and those that generate an acid by optical irradiation (photo-acid generators); however, any acid generator can be contained. Specific examples of the acid generator include the materials disclosed in paragraphs [0061] to [0085] of JP2007-199653A, but are not limited thereto.

One kind of the acid generator can be used, or two or more kinds thereof may be used in combination. When the acid generator is contained, the contained amount is preferably 0.05 to 50 parts, more preferably 0.1 to 10 parts based on 100 parts by mass of the polyether compound (A).

### [Physical Properties Regarding Film Density]

The inventive composition for forming a resist underlayer film preferably satisfies, for example, 101 < {(FT-2)/(FT-1)} × 100, where the FT-1 is a film thickness of a coating film of the composition for forming a resist underlayer film applied onto a substrate, the coating film having been subjected to baking at 180°C for 60 seconds and additional baking at 350°C for 60 seconds, and the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.

When 101 < {(FT-2)/(FT-1)} × 100, it means that the film immediately after baking is a porous film having many pores that OK73 thinner can soak into, and the higher the value, the more porous and less dense the film is. Therefore, in view of gas permeability, it is preferable that 101 < {(FT-2)/(FT-1)} × 100, and more preferable that 101.5 < {(FT-2)/(FT-1)} × 100.

When a crosslinking agent (D) is further contained, the composition preferably satisfies 100 < {(FT-2)/(FT-1)} × 100 < 103. As stated earlier, the crosslinking agent (D) has an effect of increasing the density of the film. Therefore, there are few holes for a solvent to seep into, and the swelling of the film after the reworking is suppressed. Therefore, the crosslinking agent can be contained as a crosslinking promoting agent and also a film-swelling inhibitor.

When a thermally decomposable resin (E) is further contained, it is preferable that the composition satisfies 101.5 < {(FT-2)/(FT-1)} × 100. When a thermally decomposable resin (E) is contained, the thermally decomposable resin is decomposed at the time of baking, and sublimates from within the film, and thus, fine pores can be formed in the film. Therefore, the swelling of the film after the reworking increases, so that it is possible to enhance the porosity of the film and reduce the film density.

When a crosslinking agent (D) and a thermally decomposable resin (E) are both further contained, it is also favorable for the composition to satisfy 100 < {(FT-2)/(FT-1)} × 100.

The crosslinking agent (D) and the thermally decomposable resin (E) have conflicting effects as film density modifiers, and therefore, when the two are both contained, it is sufficient to be able to observe only the curing of the film, and therefore, the film thicknesses of before and after reworking can be (FT-2) > (FT-1) when compared.

In the following, the method for manufacturing a resist underlayer film, the patterning process, and the methods for manufacturing a semiconductor device using the inventive composition for forming a resist underlayer film will be described.

### [Method for Manufacturing Resist Underlayer Film]

The inventive method for manufacturing a resist underlayer film includes:
applying the inventive composition for forming a resist underlayer film onto a semiconductor substrate to obtain a coating film; and
baking the coating film to obtain a resist underlayer film.

The semiconductor substrate, for example, a substrate used in manufacturing a semiconductor device is, for example, a silicon wafer substrate, silicon/silicon dioxide-covered substrate, silicon nitride substrate, glass substrate, ITO substrate, polyimide substrate, low dielectric constant material (low-k material)-covered substrate, etc.

Onto the semiconductor substrate, the inventive composition for forming a resist underlayer film is applied by an appropriate application means, such as a spinner or a coater to form a coating film.

Subsequently, the coating film is baked to form a resist underlayer film.

The baking conditions can be suitably selected from a baking temperature of 80°C to 400°C and a baking time of 0.3 to 60 minutes. Preferably, the baking temperature is 150°C to 350°C and the baking time is 0.5 to 2 minutes, and more preferably, the baking is a two-step baking including baking at a baking temperature of 100°C to 200°C for 0.5 to 2 minutes and then baking additionally at 200°C to 350°C for 0.5 to 2 minutes. Here, the thickness of the underlayer film formed is, for example, 10 to 1500 nm, more preferably 500 to 1000 nm. In addition, when a quartz substrate is used as the substrate, it is possible to produce a replica of a quartz imprint mold (mold replica).

It is also possible to form an adhesive layer and/or a silicone layer containing 99% by mass or less or 50% by mass or less Si by application or deposition on the resist underlayer film formed in the above manner. For example, a composition for forming an adhesive layer disclosed in JP2013-202982A or JP5827180B2 or a silicon-containing resist underlayer film (inorganic resist underlayer film) disclosed in WO2009/104552A1 can be formed by spin-coating, or alternatively, a Si-based inorganic material film can be formed by a CVD method or the like.

Furthermore, the inventive composition for forming a resist underlayer film can, as described above, form an underlayer film that exhibits enhanced flatness. For example, by applying the inventive composition for forming a resist underlayer film onto a semiconductor substrate having a portion with a step and a portion with no steps (a so-called stepped substrate) to obtain a coating film and baking the coating film, it is possible to form a resist underlayer film having a difference of 3 to 100 nm between the portion with a step and the portion with no steps.

### [Patterning Process]

The inventive patterning process includes the steps of:
forming a resist underlayer film on a semiconductor substrate by using the inventive composition for forming a resist underlayer film;
forming a curable composition film on the resist underlayer film;
bringing the curable composition film into contact with a mold;
irradiating the curable composition film with light or an electron beam to obtain a cured film; and separating the cured film from the mold.

This patterning process is called an imprinting method, using a mold. The imprinting method may be a nanoimprinting method. According to such a patterning process by way of the imprinting method of the present invention, it is possible to make use of a resist underlayer film that has favorable processing resistance, has excellent filling property and flatness, and furthermore, has low film density and exhibits favorable gas permeability. Therefore, according to the inventive patterning process by way of the imprinting method, it is possible to eliminate swiftly the bubbles generated when the mold is pressed into the curable composition film and form a fine pattern.

In the following, each step will be described in more detail.

### <Step of Forming Resist Underlayer Film>

In this step, a resist underlayer film can be formed from the inventive composition for forming a resist underlayer film on a semiconductor substrate by, for example, the inventive method for manufacturing a resist underlayer film described earlier.

### <Step of Forming Curable Composition Film>

The present step is a step of forming a curable composition film on the resist underlayer film.

The composition of the curable composition film to be formed on the resist underlayer film is not particularly limited as long as it is photosensitive to the light used in the exposure. Either a negative photoresist or a positive photoresist can be used. Examples include: a positive photoresist containing a novolak resin and a 1,2-naphthoquinonediazide sulfonic acid ester; a chemically amplified photoresist containing a binder having a group that decomposes due to an acid and increases alkali dissolution rate and a photo-acid generator; a chemically amplified photoresist containing a low-molecular-weight compound that decomposes due to an acid and increases the alkali dissolution rate of the photoresist, an alkali-soluble binder, and a photo-acid generator; a chemically amplified photoresist containing a binder having a group that decomposes due to an acid and increases alkali dissolution rate, a low-molecular-weight compound that decomposes due to an acid and increases the alkali dissolution rate of the photoresist, and a photo-acid generator; etc. Examples include APEX-E (trade name) manufactured by Shipley Company, Inc., PAR710 (trade name) manufactured by Sumitomo Chemical Co., Ltd., and SEPR430 (trade name) manufactured by Shin-Etsu Chemical Co., Ltd. Examples also include fluorine atom-containing polymer photoresists described in Proc. SPIE, Vol. 3999, 330-334 (2000), Proc. SPIE, Vol. 3999, 357-364 (2000), and Proc. SPIE, Vol. 3999, 365-374 (2000).

### [Method of Applying Curable Composition]

As a method of applying the curable composition, it is possible to use, for example, an inkjet method, a dip coating method, an air knife coating method, a curtain coating method, a wire bar coating method, a gravure coating method, an extrusion coating method, a spin coating method, and a slit-scan method. An inkjet method is suitable for applying droplets of the curable composition, and a spin coating method is suitable for coating with the curable composition. In the present step, it is possible to form an adhesive layer and/or a silicone layer containing Si in an amount of 99% by mass or less or 50% by mass or less by application or vapor deposition on the resist underlayer film for nanoimprinting and apply the curable composition onto the formed layer.

In the step of forming the curable composition film, it is also possible to form on the resist underlayer film an adhesive layer and/or a silicone layer containing 99 mass% or less Si by application or deposition.

By forming the adhesive layer, pattern delamination can be suppressed sufficiently in the step of separating the mold later. Meanwhile, by forming a silicone layer containing 99 mass% or less Si, the optical characteristics of the film can be adjusted, and reflection control and so forth is possible.

### <Step of Bringing Curable Composition Film into Contact With Mold>

In the present step, the curable composition film is allowed to come into contact with a mold. For example, when a liquid curable composition film and a mold having a prototype pattern for transferring the pattern shape are brought into contact with each other, a liquid film of the curable composition filling concave portions of the fine pattern on the surface of the mold is formed.

Taking into consideration the step of irradiating with a light or an electron beam described later, it is recommended to use a mold using a light transmitting material as a base material. The base material for the mold is, specifically, preferably glass, quartz, a light transparent resin, such as PMMA or a polycarbonate resin, a transparent metal deposited film, a flexible film, such as polydimethylsiloxane, a photo-cured film, or a metal film. The base material for the mold is more preferably quartz, which has a small coefficient of thermal expansion and which is unlikely to cause pattern strain.

The fine pattern formed on the surface of the mold preferably has a pattern height of 4 nm or more and 200 nm or less. The pattern needs an appropriately large pattern height for improving the processing accuracy for the substrate; however, the smaller the pattern height, the smaller the force needed for peeling the mold off from the cured film in the step of separating the cured film from the mold described later, and the smaller the number of defects that the resist pattern breaks and remains on the mask side. It is recommended to select and employ a pattern height with an appropriate balance when taking the above into consideration.

Further, elastic deformation of the resist pattern due to an impact of separating the mold may cause the adjacent resist patterns to come into contact with each other, so that the resist patterns suffer adhesion or breakage in some cases. This can be avoided when the pattern height is about 2 times or less the pattern width (the aspect ratio is 2 or less).

For improving the release property between the curable composition and the surface of the mold, the mold may preliminarily be subjected to surface treatment. Examples of the method for surface treatment include a method in which a release agent is applied to the surface of the mold to form a release agent layer. Examples of release agents include a silicone release agent, a fluorine release agent, a hydrocarbon release agent, a polyethylene release agent, a polypropylene release agent, a paraffin release agent, a montan release agent, and a carnauba release agent. Preferred are a fluorine release agent and a hydrocarbon release agent. Examples of commercially available release agents include OPTOOL (registered trademark) DSX, manufactured by Daikin Industries, Ltd. One kind of release agent may be used or two or more kinds may be used in combination.

In the present step, there is no particular limitation to the pressure applied to the curable composition at the time of allowing the mold and the curable composition to be in contact with each other. A pressure of 0 MPa or higher and 100 MPa or lower is recommended. The pressure is preferably 0 MPa or more and 50 MPa or less, 30 MPa or less, or 20 MPa or less.

When the prespreading of the droplets of the curable composition has proceeded in the previous step (the step of applying a curable composition), the spreading of the curable composition in the present step is quickly completed. Consequently, the time for allowing the mold and the curable composition to be in contact with each other can be reduced. The time for allowing the contact is not particularly limited, but is preferably 0.1 seconds or more and 600 seconds or less, 3 seconds or less, or 1 second or less. When the time for the contact is too short, there is concern that the spread and fill are insufficient, so that a defect called an unfilled defect is caused.

The present step may be conducted in any of an air atmosphere, an atmosphere under a reduced pressure, and an inert gas atmosphere, but is preferably conducted under a pressure of 0.0001 atm. or higher and 10 atm. or lower. For preventing an adverse effect of oxygen or moisture on the curing reaction, it is recommended that the present step should be conducted in an atmosphere under a reduced pressure or in an inert gas atmosphere. Specific examples of inert gas which may be used for creating an inert gas atmosphere include nitrogen, carbon dioxide, helium, argon, CFC, HCFC, HFC, and a mixed gas thereof.

The present step may be conducted in an atmosphere containing a condensable gas (hereinafter, referred to as "condensable gas atmosphere"). In the present specification, the term "condensable gas" means a gas such that when the gas fills, together with the curable composition, the depressed portions of the fine pattern formed in the mold as well as the gap between the mold and the substrate, the gas condenses due to a capillary pressure caused upon filling to be liquefied. The condensable gas is in a gaseous state in the atmosphere until the curable composition and the mold are made in contact with each other in the present step. When the present step is conducted in a condensable gas atmosphere, the gas that fills the depressed portions of the fine pattern is liquefied due to a capillary pressure caused by the curable composition, which results in disappearance of air bubbles, achieving excellent filling property. The condensable gas may be dissolved in the curable composition.

The boiling point of the condensable gas is not limited as long as it is not higher than the temperature of the atmosphere in the present step, but the boiling point is preferably -10°C or higher, or +10°C or higher, and +23°C or lower.

There is no particular limitation to the vapor pressure of the condensable gas at the temperature of the atmosphere in the present step as long as it is the mold pressure or less. The vapor pressure is preferably in the range of 0.1 to 0.4 MPa.

Specific examples of condensable gases include chlorofluorocarbon (CFC), such as trichlorofluoromethane; fluorocarbon (FC); hydrofluorocarbon (HFC), such as hydrochlorofluorocarbon (HCFC) and 1,1,1,3,3-pentafluoropropane (CHF₂CH₂CF₃, HFC-245 fa, PFP); and hydrofluoroether (HFE), such as pentafluoroethyl methyl ether (CF₃CF₂OCH₃, HFE-245 mc).

One kind of condensable gas may be used, or two or more kinds thereof may be used in mixture. The condensable gas may be used in the form of a mixture with a noncondensable gas, such as air, nitrogen, carbon dioxide, helium, or argon. As a noncondensable gas to be mixed with the condensable gas, air or helium is preferred.

### <Step of Irradiating Curable Composition Film with Light or Electron Beam to Form Cured Film>

In the present step, the curable composition film is irradiated with light or an electron beam to form a cured film. That is, the curable composition film filling the fine pattern in the mold is irradiated with light or an electron beam through the mold to cure the curable composition filling the fine pattern in the mold in such a state, forming a cured film having a pattern form.

The light or electron beam is selected according to the sensitivity wavelength of the curable composition. Specifically, the light or electron beam may be appropriately selected from an ultraviolet light having a wavelength of 150 nm or more and 400 nm or less, an X-ray, an electron beam, etc. Examples of the light sources for the light or electron beam include a highpressure mercury lamp, an ultrahigh-pressure mercury lamp, a low-pressure mercury lamp, a Deep-UV lamp, a carbon-arc lamp, a chemical lamp, a metal halide lamp, a xenon lamp, a KrF excimer laser, an ArF excimer laser, and an F₂ excimer laser. A single light source or two or more light sources may be used. Irradiation may be performed with respect to the whole of the curable composition filling the fine pattern in the mold, or may be performed with respect to only a partial region. The irradiation may be carried out on the entire region of the substrate with a light intermittently two or more times, or on the entire region with a light continuously. Alternatively, the irradiation may be carried out in such a manner that the first irradiation is performed on a partial region of the substrate, and the second irradiation is performed on a region different from the above partial region.

The cured film thus obtained preferably has a pattern having a size of 1 nm or more or 10 nm or more, and 10 mm or less or 100 um or less.

### <Step of Separating Cured Film from Mold>

In the present step, the cured film and the mold are separated. The cured film having a pattern form is separated from the mold, so as to obtain a cured film having a pattern form in a self-supporting state, which corresponds to the reverse pattern of the fine pattern formed in the mold.

There is no particular limitation to the method of separating the mold and the cured film having a pattern form provided that the method moves the cured film and the mold in such a direction that the cured film and the mold are apart from each other, and that no part of the cured film having a pattern form physically breaks, and various conditions and others are not particularly limited, either. For example, the cured film and the mold may be separated by fixing the substrate and moving the mold so as to move away from the substrate, or by fixing the mold and moving the substrate so as to move away from the mold. Alternatively, the substrate and the mold may be separated by pulling and moving them in opposite directions.

In the case where the above-described step of bringing the curable composition into contact with a mold is conducted in a condensable gas atmosphere, the pressure of the interface at which the cured film and the mold are in contact is reduced when the cured film and the mold are separated in the present step, and thus, the condensable gas is vaporized. By virtue of this, it is possible to reduce the release force, which is a force needed for separating the cured film from the mold.

A cured film having in a desired position a desired uneven pattern form derived from the uneven form of the mold can be prepared through the above-described steps.

Note that, although a patterning process using an imprinting method is described in the above, the resist underlayer film obtained from the inventive composition for forming a resist underlayer film is not limited to use in patterning processes using an imprinting method, and can also be used, for example, as a resist underlayer film in a patterning process according to a multilayer resist process.

### [Method for Manufacturing Semiconductor Device]

A first embodiment of the inventive method for manufacturing a semiconductor device includes the steps of:
forming a resist underlayer film on a semiconductor substrate by using the inventive composition for forming a resist underlayer film;
forming a resist film on the resist underlayer film;
subjecting the resist film to irradiation with light or an electron beam and then to development to form a resist pattern;
etching the resist underlayer film while using the formed resist pattern as a mask to obtain a patterned underlayer film; and
processing the semiconductor substrate while using the patterned underlayer film as a mask.

A second embodiment of the inventive method for manufacturing a semiconductor device includes the steps of:
forming a resist underlayer film on a semiconductor substrate by using the inventive composition for forming a resist underlayer film;
forming a hard mask on the resist underlayer film;
further forming a resist film on the hard mask;
subjecting the resist film to irradiation with light or an electron beam and then to development to form a resist pattern;
etching the hard mask while using the formed resist pattern as a mask to obtain a patterned hard mask;
etching the underlayer film while using the patterned hard mask as a mask to obtain a patterned resist underlayer film; and
processing the semiconductor substrate while using the patterned resist underlayer film as a mask.

In the following, the first embodiment of the method for manufacturing a semiconductor device and the second embodiment of the method for manufacturing a semiconductor device will be described in turn in more detail.

### <First Embodiment>

### [Step of Forming Resist Underlayer Film on Semiconductor Substrate by Using Inventive Composition for Forming Resist Underlayer Film]

In this step, a resist underlayer film can be formed, for example, by the inventive method for manufacturing a resist underlayer film described earlier.

### [Step of Forming Resist Film on Resist Underlayer Film]

Subsequently, the step of forming a resist film on the resist underlayer film is performed.

The material for the resist film is not particularly limited as long as it is a resist material used in a multilayer resist method.

### [Step of Subjecting Resist Film to Irradiation with Light or Electron Beam and Then to Development to Form Resist Pattern]

Subsequently, the resist film formed in the above manner is irradiated with light or an electron beam and then developed to form a resist pattern.

The light or electron beam for irradiation can be selected appropriately depending on the properties of the resist film. The method for the development is not particularly limited either as long as it is a method used in a multilayer resist method.

### [Step of Etching Resist Underlayer Film While Using Formed Resist Pattern as Mask to Obtain Patterned Underlayer Film]

Subsequently, the resist underlayer film is etched while using the resist pattern formed earlier as a protective film.

The etching in this step is preferably performed under conditions under which the resist underlayer film is more readily etched than the resist film. For example, when the resist film contains many silicon atoms, it is difficult for the resist film to be removed by dry etching using an oxygen-based gas and the resist underlayer film is etched more, and therefore, the etching is preferably performed by dry etching using an oxygen-based gas.

By this step, a patterned underlayer film can be obtained.

### [Step of Processing Semiconductor Substrate While Using Patterned Underlayer Film as Mask]

Subsequently, the step of processing the semiconductor substrate while using the patterned underlayer film as a mask is performed.

The semiconductor substrate is preferably processed by dry etching with a fluorine-based gas.

Examples of fluorine-based gas include tetrafluoromethane (CF₄), perfluorocyclobutane (C₄F₈), perfluoropropane (C₃F₈), trifluoromethane, and difluoromethane (CH₂F₂).

### <Second Embodiment>

The second embodiment differs from the first embodiment in that a hard mask is formed on the resist underlayer film, the hard mask is etched while using the resist pattern as a mask, and the resist underlayer film is etched while using the patterned hard mask. In the following, the second embodiment will be described mainly focusing on points that are different from the first embodiment.

The material for the hard mask is not particularly limited as long as it is a material for a hard mask usable in a multilayer resist process.

For the etching of an inorganic hard mask, dry etching can be used, for example. For the dry etching of an inorganic hard mask, it is possible to use, for example, a gas of tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride, chlorine trifluoride, chlorine, trichloroborane, dichloroborane, etc. For the dry etching of an inorganic hard mask, a halogen-based gas is preferably used, more preferably a fluorine-based gas. Examples of fluorine-based gas include tetrafluoromethane (CF₄), perfluorocyclobutane (C₄F₈), perfluoropropane (C₃F₈), trifluoromethane, and difluoromethane (CH₂F₂).

As in the second embodiment, in the present invention, the substrate can be processed when an appropriate etching gas is selected, even when the resist film has a narrow pattern width and a thin layer of the resist film is formed to prevent pattern collapse. The processing of the substrate is made possible by forming a resist underlayer film on a substrate, then forming a hard mask thereon, and further covering the hard mask with a resist film. For example, the hard mask can be processed by using as an etching gas a fluorine-based gas, which allows a sufficiently high etching rate relative to that of the resist film, the resist underlayer film can be processed by using as an etching gas a fluorine-based gas, which allows a sufficiently high etching rate relative to that of the hard mask, and furthermore, the substrate can be processed by using as an etching gas an oxygen-based gas, which allows a sufficiently high etching rate relative to that of the resist underlayer film.

In both the first embodiment and the second embodiment, an organic antireflective film can be formed above the resist underlayer film before forming the resist film or the hard mask. The antireflective film composition used in this event is not particularly limited, and any antireflective film composition may be selected from those which have been usually used in a lithography process, and an antireflective film may be formed by a method usually used, for example, by applying the composition by using a spinner or coater followed by baking.

The resist underlayer film formed from the inventive composition for forming a resist underlayer film may have an absorption with respect to the light used in a lithography process depending on the wavelength of the light. In such a case, the resist underlayer film may function as an antireflective film having an effect of preventing a light reflected from the substrate. Further, the underlayer film formed from the inventive composition for forming a resist underlayer film may also function as a hard mask in the first embodiment. The underlayer film of the present invention may also be used as: a layer for preventing an interaction between a substrate and a resist film; a layer having a function for preventing any adverse effect on a substrate by the materials used in the resist film or by the substances formed during the exposure of the resist film; a layer having a function for preventing the diffusion of the substances generated from the substrate upon heating or baking into the resist film; a barrier layer for reducing the poisoning effect of the resist film by the semiconductor substrate dielectric layer; etc.

Moreover, the underlayer film formed from the inventive composition for forming a resist underlayer film may be applied to a substrate having formed via holes used in a dual-damascene process, and may be used as an encapsulation material capable of filling holes without gaps. Furthermore, the underlayer film may also be used as a planarization material for planarizing the uneven surface of a semiconductor substrate.

As described earlier, the inventive composition for forming a resist underlayer film can realize a resist underlayer film that has excellent filling property and flatness and can exhibit hardness to withstand processing. Therefore, the inventive composition for forming a resist underlayer film is also extremely useful in a method for manufacturing a semiconductor device including pattern formation by a multilayer resist method as described above.

### EXAMPLES

Hereinafter, the present invention will be further specifically described with reference to Synthesis Examples, Comparative Synthesis Examples, Examples, and Comparative Examples. However, the present invention is not limited to these Examples. Note that, as the molecular weight, weight-average molecular weight (Mw) in terms of polystyrene was determined by gel permeation chromatography (GPC) using tetrahydrofuran as an eluent.

### [Synthesis Examples and Comparative Synthesis Examples]

In each of the following Synthesis Examples and Comparative Synthesis Examples, any of the aromatic compound group Ar₁ ((Ar₁-1) to (Ar₁-8)), any of the polyetherifying agent group ((G1) to (G5)), and any of etherifying agent group ((R₁-1) to (R₁-8)) shown below were used. The respective starting material groups are shown below.

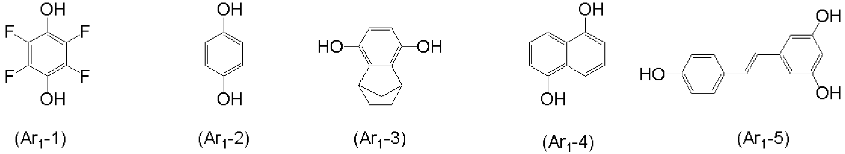

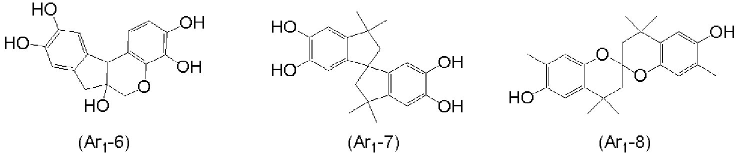

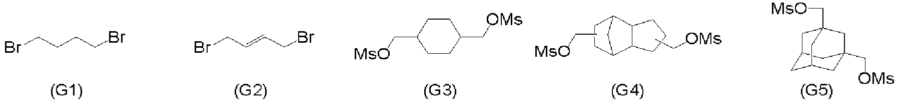

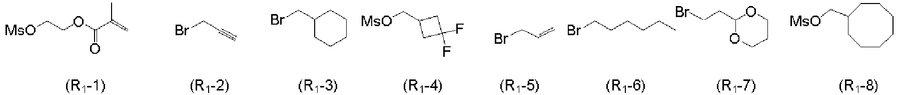

Ms represents a methanesulfonyl group.

### [Synthesis Example 1] Synthesis of Compound (A-1) for Forming Resist Underlayer Film

10.0 g of the aromatic compound (Ar₁-1), 13.2 g of the polyetherifying agent (G3), 16.7 g of potassium carbonate, and 30 g of N,N-dimethylformamide (DMF) were mixed, and the mixture was stirred at 120°C for 6 hours. After that, the temperature of the mixture was lowered to 90°C, 4.6 g of the etherifying agent (R₁-1) and a solution of 10.0 g of DMF were added dropwise to the mixture, and the mixture was further stirred for 16 hours. After the reaction, the mixture was restored to room temperature, and the product was dissolved in 150 ml of methyl isobutyl ketone (MIBK), washed twice with 100 ml of ultrapure water, further washed with 100 ml of a 3% aqueous nitric acid solution, and further washed four times with 100 ml of ultrapure water. Subsequently, the solvent was removed under reduced pressure, 200 g of propylene glycol monomethyl ether acetate (PGMEA) was added to the residue, and again, the solvent was removed under reduced pressure to perform PGMEA substitution. Thus, a solution of a compound (A-1), being a polyether compound, for forming a resist underlayer film in PGMEA was obtained.

### (A-1): Mw=2198

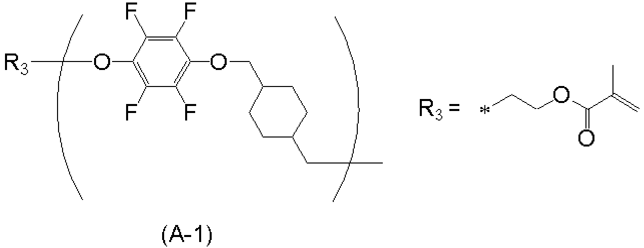

### [Synthesis Example 2] Synthesis of Compound (A-2) for Forming Resist Underlayer Film

A solution of a compound (A-2), being a polyether compound, for forming a resist underlayer film in PGMEA was obtained by the same method as in Synthesis Example 1, except that the 10.0 g of the aromatic compound (Ar₁-1) of Synthesis Example 1 was changed to 10.0 g of the aromatic compound (Ar₁-2), the amount of the polyetherifying agent (G3) used was changed to 21.8 g, the amount of the potassium carbonate used was changed to 27.6 g, and the amount of the etherifying agent (R₁-1) used was changed to 7.5 g.

### (A-2): Mw=2439

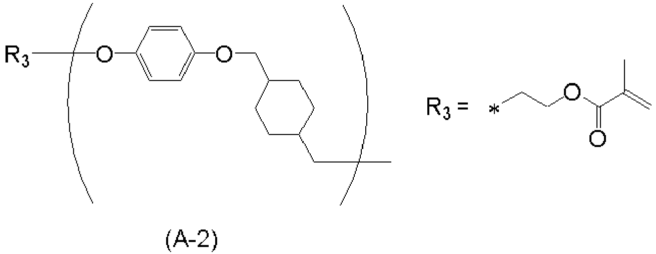

### [Synthesis Example 3] Synthesis of Compound (A-3) for Forming Resist Underlayer Film

A solution of a compound (A-3), being a polyether compound, for forming a resist underlayer film in PGMEA was obtained by the same method as in Synthesis Example 1, except that the 10.0 g of the aromatic compound (Ar₁-1) of Synthesis Example 1 was changed to 10.0 g of the aromatic compound (Ar₁-3), the amount of the polyetherifying agent (G3) used was changed to 13.6 g, the amount of the potassium carbonate used was changed to 17.3 g, and the amount of the etherifying agent (R₁-1) used was changed to 4.7 g.

### (A-3): Mw=2615

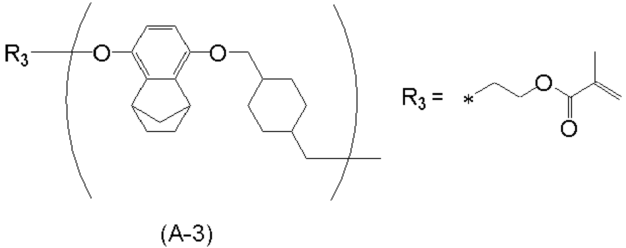

### [Synthesis Example 4] Synthesis of Compound (A-4) for Forming Resist Underlayer Film

A solution of a compound (A-4), being a polyether compound, for forming a resist underlayer film in PGMEA was obtained by the same method as in Synthesis Example 1, except that the 10.0 g of the aromatic compound (Ar₁-1) of Synthesis Example 1 was changed to 10.0 g of the aromatic compound (Ar₁-4), the amount of the polyetherifying agent (G3) used was changed to 15.0 g, the amount of the potassium carbonate used was changed to 19.0 g, and the amount of the etherifying agent (R₁-1) used was changed to 5.2 g.

### (A-4): Mw=2320

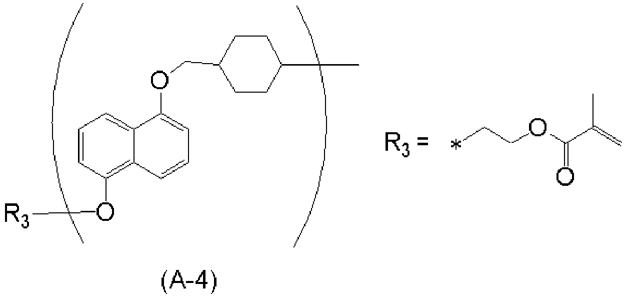

### [Synthesis Example 5] Synthesis of Compound (A-5) for Forming Resist Underlayer Film

A solution of a compound (A-5), being a polyether compound, for forming a resist underlayer film in PGMEA was obtained by the same method as in Synthesis Example 1, except that the 10.0 g of the aromatic compound (Ar₁-1) of Synthesis Example 1 was changed to 10.0 g of the aromatic compound (Ar₁-5), the polyetherifying agent (G3) was changed to 7.6 g of the polyetherifying agent (G1), the amount of the potassium carbonate used was changed to 20.0 g, the etherifying agent (R₁-1) was changed to 9.8 g of the etherifying agent (R₁-2), and the reaction temperature was changed to 60°C.

### (A-5): Mw=5594

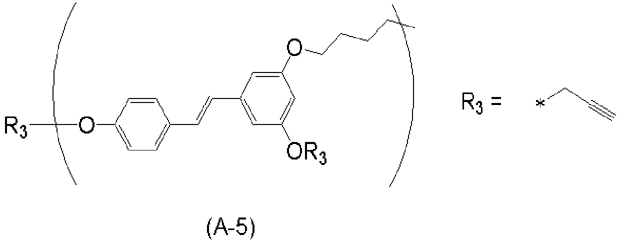

### [Synthesis Example 6] Synthesis of Compound (A-6) for Forming Resist Underlayer Film

10.0 g of the aromatic compound (Ar₁-6), 7.9 g of the polyetherifying agent (G3), 20.1 g of potassium carbonate, and 30 g of DMF were mixed, and the mixture was stirred at 120°C for 6 hours. After that, the temperature of the mixture was lowered to 90°C, 3.5 g of the etherifying agent (R₁-3) was added thereto, and a reaction was allowed to take place for 6 hours. Then, the temperature of the reaction product was set to 50°C, 8.9 g of the etherifying agent (R₁-2) was added thereto, and a reaction was allowed to take place for 16 hours. The reaction product was restored to room temperature, washed with 300 ml of MIBK and 200 ml of water, and washed with 150 ml of a 3% aqueous nitric acid solution. Furthermore, the reaction product was washed four times with 200 ml of water, and the solvent was removed under reduced pressure. Subsequently, 300 g of PGMEA was added to the residue, and again, the solvent was removed under reduced pressure to perform PGMEA substitution. Thus, a solution of a compound (A-6), being a polyether compound, for forming a resist underlayer film in PGMEA was obtained.

### (A-6): Mw=6240

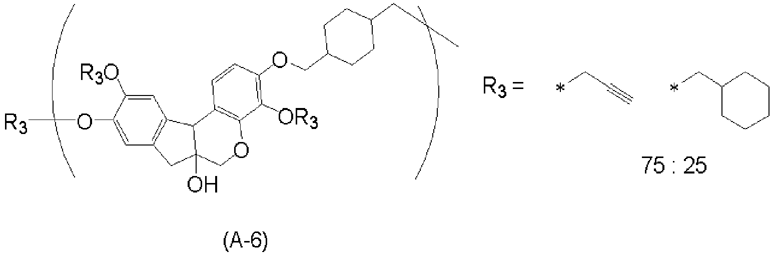

### [Synthesis Example 7] Synthesis of Compound (A-7) for Forming Resist Underlayer Film

10.0 g of the aromatic compound (Ar₁-7), 5.1 g of the polyetherifying agent (G1), 17.9 g of potassium carbonate, and 30 g of DMF were mixed, and the mixture was stirred at 80°C for 6 hours. After that, the temperature of the mixture was set to 90°C, 3.1 g of the etherifying agent (R₁-3) was added thereto, and a reaction was allowed to take place for 6 hours. Then, the temperature of the reaction product was set to 50°C, 7.9 g of the etherifying agent (R₁-2) was added thereto, and a reaction was allowed to take place for 16 hours. The reaction product was restored to room temperature, washed with 300 ml of MIBK and 200 ml of water, and washed with 150 ml of a 3% aqueous nitric acid solution. Furthermore, the reaction product was washed four times with 200 ml of water, the solvent was removed under reduced pressure, 300 g of PGMEA was added to the residue, and again, the solvent was removed under reduced pressure to perform PGMEA substitution. Thus, a solution of a compound (A-7), being a polyether compound, for forming a resist underlayer film in PGMEA was obtained.

### (A-7): Mw=4425

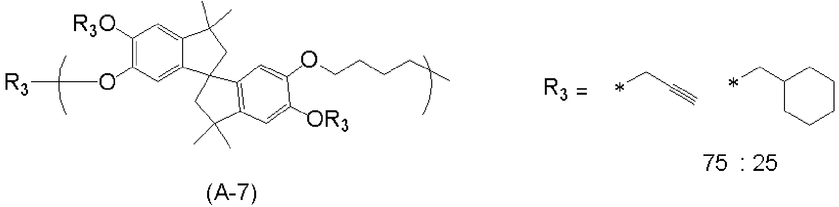

### [Synthesis Example 8] Synthesis of Compound (A-8) for Forming Resist Underlayer Film

A solution of a compound (A-8), being a polyether compound, for forming a resist underlayer film in PGMEA was obtained by the same method as in Synthesis Example 7, except that the polyetherifying agent (G1) of Synthesis Example 7 was changed to 5.0 g of the polyetherifying agent (G2), the etherifying agent (R₁-3) was changed to 3.5 g of the etherifying agent (R₁-4), and the etherifying agent (R₁-2) was changed to 6.4 g of the etherifying agent (R₁-5).

### (A-8): Mw=4400

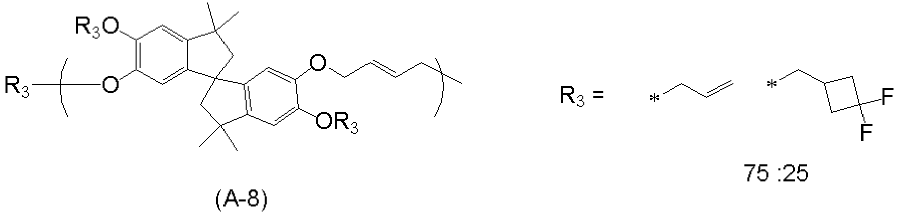

### [Synthesis Example 9] Synthesis of Compound (A-9) for Forming Resist Underlayer Film

A solution of a compound (A-9), being a polyether compound, for forming a resist underlayer film in PGMEA was obtained by the same method as in Synthesis Example 8, except that the etherifying agent (R₁-4) of Synthesis Example 8 was changed to 3.1 g of the etherifying agent (R₁-3), and the etherifying agent (R₁-5) was changed to 7.9 g of the etherifying agent (R₁-2).

### (A-9): Mw=4515

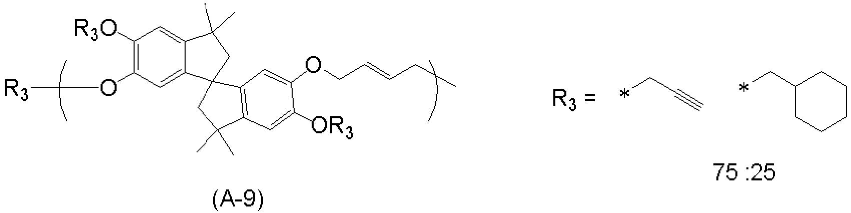

### [Synthesis Example 10] Synthesis of Compound (A-10) for Forming Resist Underlayer Film

A solution of a compound (A-10), being a polyether compound, for forming a resist underlayer film in PGMEA was obtained by the same method as in Synthesis Example 9, except that the etherifying agent (R₁-3) of Synthesis Example 9 was changed to 2.9 g of the etherifying agent (R₁-6).

### (A-10): Mw=4550

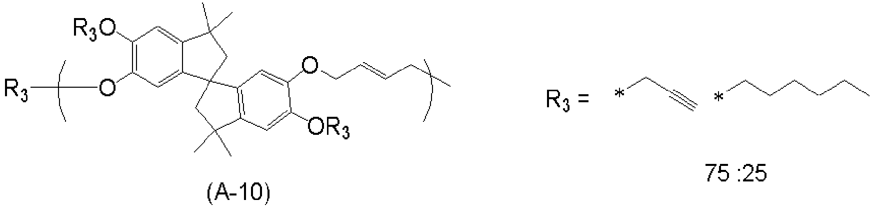

### [Synthesis Example 11] Synthesis of Compound (A-11) for Forming Resist Underlayer Film

10.0 g of the aromatic compound (Ar₁-7), 7.1 g of the polyetherifying agent (G3), 17.9 g of potassium carbonate, and 30 g of DMF were mixed, and the mixture was stirred at 120°C for 6 hours. After that, the temperature of the mixture was set to 90°C, 3.1 g of the etherifying agent (R₁-3) was added thereto, and a reaction was allowed to take place for 6 hours. Then, the temperature of the reaction product was set to 50°C, 7.9 g of the etherifying agent (R₁-2) was added thereto, and a reaction was allowed to take place for 16 hours. The reaction product was restored to room temperature, washed with 300 ml of MIBK and 200 ml of water, and washed with 150 ml of a 3% aqueous nitric acid solution. Furthermore, the reaction product was washed four times with 200 ml of water, the solvent was removed under reduced pressure, 300 g of PGMEA was added to the residue, and again, the solvent was removed under reduced pressure to perform PGMEA substitution. Thus, a solution of a compound (A-11), being a polyether compound, for forming a resist underlayer film in PGMEA was obtained.

### (A-11): Mw=4820

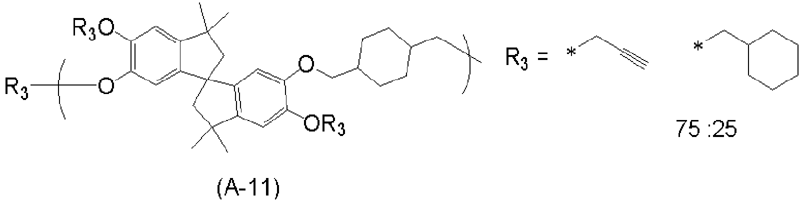

### [Synthesis Example 12] Synthesis of Compound (A-12) for Forming Resist Underlayer Film

A solution of a compound (A-12), being a polyether compound, for forming a resist underlayer film in PGMEA was obtained by the same method as in Synthesis Example 11, except that the polyetherifying agent (G3) of Synthesis Example 11 was changed to 9.0 g of the polyetherifying agent (G4), and the etherifying agent (R₁-3) was changed to 3.9 g of the etherifying agent (R₁-8) .

### (A-12): Mw=4705

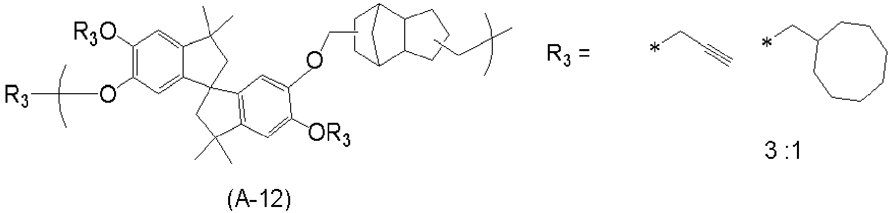

### [Synthesis Example 13] Synthesis of Compound (A-13) for Forming Resist Underlayer Film

A solution of a compound (A-13), being a polyether compound, for forming a resist underlayer film in PGMEA was obtained by the same method as in Synthesis Example 11, except that the polyetherifying agent (G1) of Synthesis Example 11 was changed to 8.3 g of the polyetherifying agent (G5), and the etherifying agent (R₁-3) was changed to 3.4 g of the etherifying agent (R₁-7) .

### (A-13): Mw=4611

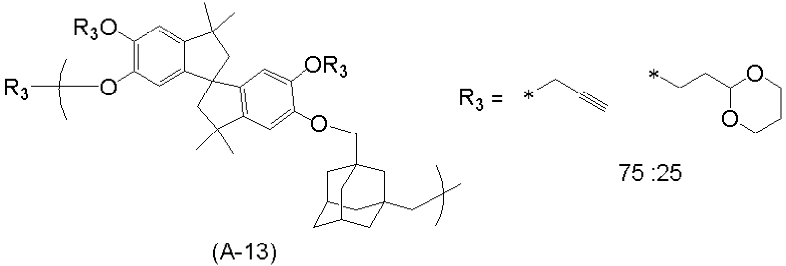

### [Synthesis Example 14] Synthesis of Compound (A-14) for Forming Resist Underlayer Film

A solution of a compound (A-14), being a polyether compound, for forming a resist underlayer film in PGMEA was obtained by the same method as in Synthesis Example 1, except that the aromatic compound (Ar₁-1) of Synthesis Example 1 was changed to 10.0 g of the aromatic compound (Ar₁-8), the amount of the polyetherifying agent (G3) used was changed to 6.5 g, the amount of the potassium carbonate used was changed to 8.3 g, and the amount of the etherifying agent (R₁-2) used was changed to 2.0 g.

### (A-14): Mw=7100

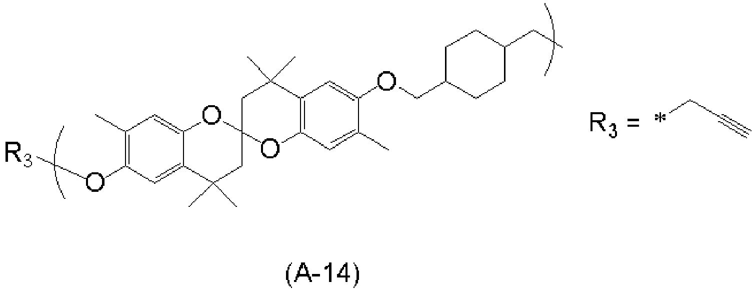

### [Synthesis Example 15] Synthesis of Compound (A-15) for Forming Resist Underlayer Film

5.0 g of the aromatic compound (Ar₁-2), 5.0 g of the aromatic compound (Ar₁-7), 14.4 g of the polyetherifying agent (G3), 22.7 g of potassium carbonate, and 30 g of N,N-dimethylformamide (DMF) were mixed, and the mixture was stirred at 120°C for 6 hours. After that, the temperature was set to 90°C, 2.4 g of the etherifying agent (R₁-3) was added thereto, and a reaction was allowed to take place for 6 hours. Then, the temperature was set to 50°C, 4.9 g of the etherifying agent (R₁-2) was added thereto, and a reaction was allowed to take place for 16 hours. After the reaction, the mixture was restored to room temperature, and the product was dissolved in 150 ml of methyl isobutyl ketone (MIBK), washed twice with 100 ml of ultrapure water, further washed with 100 ml of a 3% aqueous nitric acid solution, and further washed four times with 100 ml of ultrapure water. Subsequently, the solvent was removed under reduced pressure, 200 g of propylene glycol monomethyl ether acetate (PGMEA) was added to the residue, and again, the solvent was removed under reduced pressure to perform PGMEA substitution. Thus, a solution of a compound (A-15), being a polyether compound, for forming a resist underlayer film in PGMEA was obtained.

### (A-15): Mw=3230

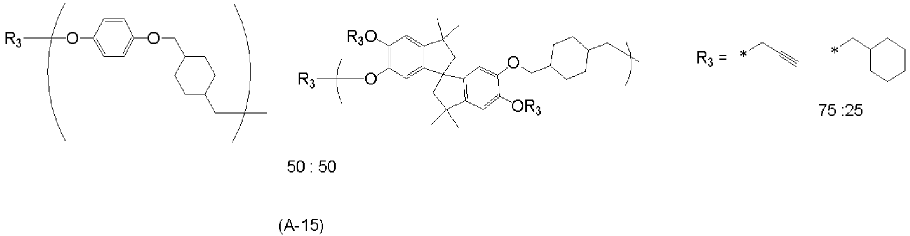

### [Synthesis Example 16] Synthesis of Compound (A-16) for Forming Resist Underlayer Film

A solution of a compound (A-16), being a polyether compound, for forming a resist underlayer film in PGMEA was obtained by the same method as in Synthesis Example 7, except that the amount of the polyetherifying agent (G1) of Synthesis Example 7 used was changed to 2.5 g, and furthermore, 3.5 g of the polyetherifying agent (G3) was used.

### (A-16): Mw=4344

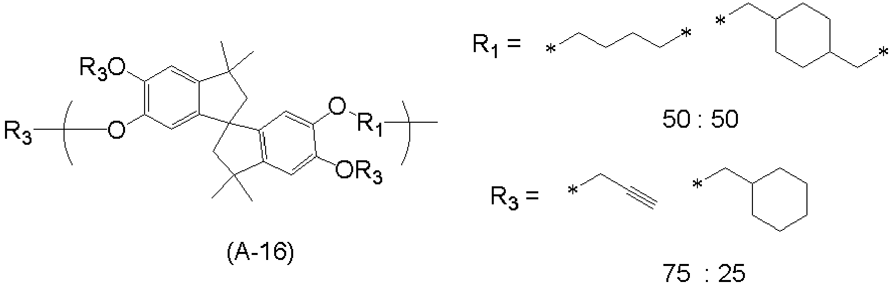

### [Synthesis Example 17] Synthesis of Compound (A-17) for Forming Resist Underlayer Film

A solution of a compound (A-17), being a polyether compound, for forming a resist underlayer film in PGMEA was obtained by the same method as in Synthesis Example 11, except that the amount of the polyetherifying agent (G3) of Synthesis Example 11 used was changed to 10.6 g.

### (A-17): Mw=13500

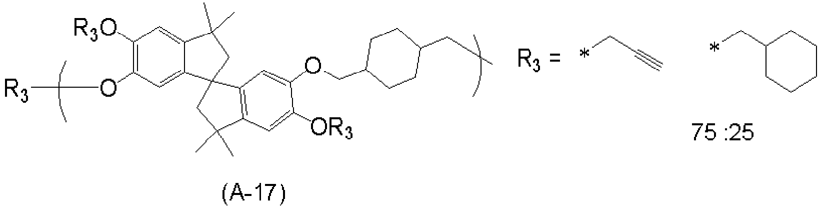

### [Comparative Synthesis Example 1] Synthesis of Compound (R-1) for Forming Resist Underlayer Film

10.0 g of 1,7-dihydroxynaphthalene, 4.8 g of a 37% aqueous formaldehyde solution, 0.3 g of p-toluenesulfonic acid monohydrate, and 30 g of PGME were mixed, and the mixture was stirred at 120°C for 20 hours. The obtained mixture was washed twice with 200 ml of MIBK and 150 ml of water. The solvent was removed from the mixture under reduced pressure, then 200 g of dimethylformamide was added to the residue, and the solvent was further removed under reduced pressure. Subsequently, 19.0 g of potassium carbonate and 80 g of additional DMF were added to the residue, the mixture was stirred at 55°C, 20.4 g of the etherifying agent (R₁-2) was added dropwise thereto, and a reaction was allowed to take place for 20 hours. The reaction product was restored to room temperature, washed with 300 ml of MIBK and 200 ml of water, and washed with 150 ml of a 3% aqueous nitric acid solution. Furthermore, the reaction product was washed four times with 200 ml of water, the solvent was removed under reduced pressure, 300 g of PGMEA was added to the residue, and again, the solvent was removed under reduced pressure to perform PGMEA substitution. Thus, a solution of a compound (R-1) for forming a resist underlayer film in PGMEA was obtained.

### (R-1): Mw=5324

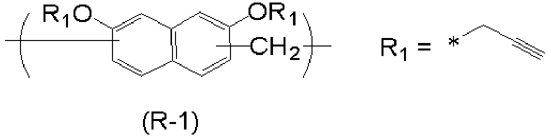

### [Comparative Synthesis Example 2] Synthesis of Compound (R-2) for Forming Resist Underlayer Film

10.0 g of 1,5-dihydroxynaphthalene, 10.13 g of 4-tert-butylbenzaldehyde, 50 g of PGMEA, and 1.2 g of methanesulfonic acid were mixed and allowed to react at 150°C for 2 hours. After the reaction was completed, the reaction solution was added dropwise to a mixed solution of methanol and water and reprecipitated, and the supernatant was decanted. 100 g of PGMEA was added to the residue, and the mixture was dried under reduced pressure to perform solvent substitution. Thus, a solution of a compound (R-2) for forming a resist underlayer film in PGMEA was obtained.

### (R-2): Mw=4110

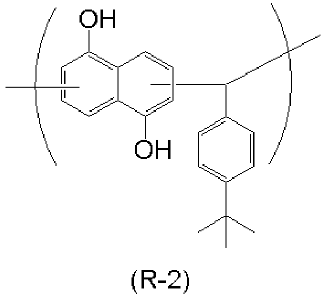

### [Comparative Synthesis Example 3] Synthesis of Compound (R-3) for Forming Resist Underlayer Film

10.0 g of phenylnaphthylamine, 8.2 g of 9-fluorenone, 1.3 g of methanesulfonic acid, and 20 g of propylene glycol monomethyl ether acetate were mixed together. Subsequently, the mixture was heated to reflux under nitrogen and allowed to react for 14 hours. After the reaction was terminated, the reaction product was reprecipitated with methanol, and the upper layer was decanted, then 100 g of PGMEA was added to the residue, and the mixture was dried under reduced pressure. Thus, a solution of a compound (resin) (R-3) for forming a resist underlayer film in PGMEA was obtained.

### (R-3): Mw=1900

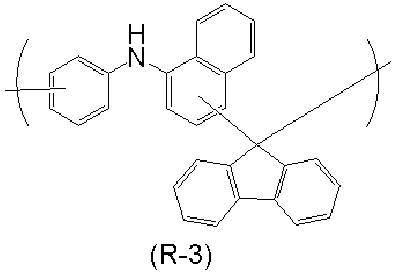

### [Preparation of Composition UDL-1 for Forming Resist Underlayer Film]

The resin (A-1) was dissolved at a ratio shown in Table 1 in propylene glycol monomethyl ether acetate (PGMEA) containing 0.5 mass% of a surfactant FC-4430 (manufactured by Sumitomo 3M Limited), and the obtained mixture was filtered through a 0.02-µm membrane filter to prepare a composition (UDL-1) for forming a resist underlayer film.

### [Preparation of Compositions (UDL-2 to -24) for Forming Resist Underlayer Film and Comparative Compositions (Comparative UDL-1 to -3) for Forming Resist Underlayer Film]

Each chemical solution was prepared in the same manner as UDL-1, except that the kind and the contained amount of each component were as shown in Table 1. In Table 1, "-" indicates that the component was not used. As the comparative compound (R-4), polyethylene glycol monomethyl ether acrylate (n=approx. 13) of Tokyo Chemical Industry Co., Ltd. was used, for the crosslinking agent, the following formula (D-1) was used, for the thermally decomposable resin, the following formula (E-1) was used, as the high-boiling-point solvent, 1,6-diacetoxyhexane (B2-1), having a boiling point of 260°C, was used, and for the thermal acid generator, the following formula (TAG-1) was used.

### [Comparative Compound]

The comparative compound (R-4) is shown below.

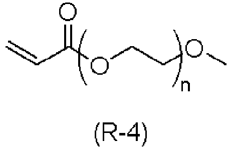

### [Crosslinking Agent]

The crosslinking agent (D-1) used in compositions for forming a resist underlayer film is shown below.

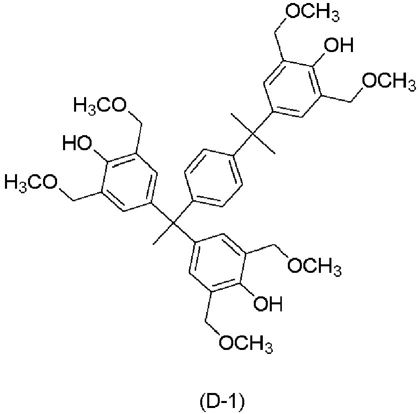

### [Thermally Decomposable Resin Synthesis Example]

### Synthesis of Thermally Decomposable Resin (E-1)

To a mixture of 3.8 g of a cation exchange resin (amberlyst (registered trademark) 15) and 100 g of ethyl acetate, 100 g of diethylene glycol monovinyl ether was added at room temperature, and the mixture was further stirred for 3 hours. To the obtained mixture, 0.8 g of triethylamine was added, and after terminating the reaction, the cation exchange resin was removed by filtration. By concentrating the filtrate under reduced pressure, 100 g of the thermally decomposable resin (E-1) was obtained as a highly viscous liquid.

The weight-average molecular weight (Mw) and the dispersity (Mw/Mn) were determined by GPC, and the following results were obtained. Mw=5,200, Mw/Mn=2.64.

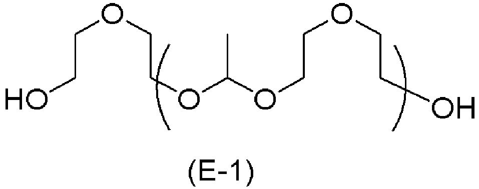

### [Thermal Acid Generator]

The thermal acid generator (TAG-1) used in a composition for forming a resist underlayer film is shown below.

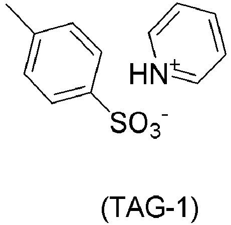

**[Table 1]**

| Composition for forming resist underlayer film | Resin | Additive | Solvent |
|---|---|---|---|
| | (parts by mass) | (parts by mass) | (parts by mass) |
| UDL-1 | A-1 (10) | - | PGMEA (90) |
| UDL-2 | A-2 (10) | - | PGMEA (90) |
| UDL-3 | A-3 (10) | - | PGMEA (90) |
| UDL-4 | A-4 (10) | - | PGMEA (90) |
| UDL-5 | A-5 (8) | - | PGMEA (92) |
| UDL-6 | A-6 (8) | - | PGMEA (92) |
| UDL-7 | A-7 (8) | - | PGMEA (92) |
| UDL-8 | A-8 (8) | - | PGMEA (92) |
| UDL-9 | A-9 (8) | - | PGMEA (92) |
| UDL-10 | A-10 (8) | - | PGMEA (92) |
| UDL-11 | A-11 (9) | - | PGMEA (91) |
| UDL-12 | A-12 (8) | - | PGMEA (92) |
| UDL-13 | A-13 (8) | - | PGMEA (92) |
| UDL-14 | A-14 (8) | - | PGMEA (92) |
| UDL-15 | A-15 (9) | - | PGMEA (92) |
| UDL-16 | A-16 (9) | - | PGMEA (91) |
| UDL-17 | A-17 (8) | - | PGMEA (92) |
| UDL-18 | A-6 (8) | D-1 (3) | PGMEA (92) |
| UDL-19 | A-9 (8) | D-1 (3) | PGMEA (92) |
| UDL-20 | A-11 (9) | D-1 (3) | PGMEA (91) |
| UDL-21 | A-6 (8) | E-1 (1) | PGMEA (92) |
| UDL-22 | A-9 (8) | E-1 (1) | PGMEA (92) |
| UDL-23 | A-11 (9) | E-1 (1) | PGMEA (91) |
| UDL-24 | A-9 (8) | - | PGMEA (92) |
| | | | B2-1 (2.5) |
| UDL-25 | A-11 (9) | - | PGMEA (91) |
| | | | B2-1 (2.5) |
| UDL-26 | A-11 (9) | D-1 (3) | PGMEA (91) |
| | | E-1 (1) | |
| Comparative UDL-1 | R-1 (9) | - | PGMEA (91) |
| Comparative UDL-2 | R-2 (8) | - | PGMEA (92) |
| Comparative UDL-3 | R-3 (8) | D-1 (2) | PGMEA (92) |
| | | TAG-1 (0.2) | |
| Comparative UDL-4 | R-4 (10) | - | PGMEA (90) |

### [Solvent Resistance Test]

Each of the compositions (UDL-1 to -26 and comparative UDL-1 to -4) for forming a resist underlayer film prepared as described above was respectively applied onto a silicon substrate to obtain a coating film. The obtained coating film was baked at 180°C for 60 seconds, and then further baked at 350°C for 60 seconds. Thus, resist underlayer films each having a film thickness of about 200 nm were formed.

The film thickness (FT-1 [nm]) of the formed resist underlayer film was measured. Furthermore, on the resist underlayer film, OK73 thinner (propylene glycol monomethyl ether/propylene glycol monomethyl ether acetate = 7/3) was dispensed and then left to stand for 30 seconds, then the resist underlayer film was spin-dried, and then the resist underlayer film was baked at 100°C for 60 seconds to evaporate the OK73 thinner (the resist underlayer film was reworked). The film thickness (FT-2 [nm]) of the resist underlayer film reworked in this manner was measured.

The film thickness difference (film remaining percentage: (FT-2/FT-1)×100) between before and after the treatment was calculated. The results are shown later in Table 2.

### [Contact Angle Measurement and Hardness Measurement]

Each of the compositions (UDL-1 to -26 and comparative UDL-1 to -4) for forming a resist underlayer film prepared as described above was respectively applied onto a silicon substrate to obtain a coating film. Subsequently, the coating film was baked at 180°C for 60 seconds, and then further baked at 350°C for 60 seconds. Thus, resist underlayer films each having a film thickness of about 200 nm were formed.

The contact angle of each of these resist underlayer films with pure water was measured. In addition, a nanoindentation test was performed using a nanoindenter SA2-type apparatus manufactured by TOYO Corporation to measure the hardness of the resist underlayer films. The results are shown in Table 2.

**[Table 2]**

| Example | Composition for forming resist underlayer film | Film Thickness (FT-1) | Film Thickness after Rinsing (FT-2) | (FT-2/ FT-1) ×100 | Contact Angle with Pure Water | Hardness |
|---|---|---|---|---|---|---|
| | | nm | nm | % | Degrees | Gp a |
| Example 1-1 | UDL-1 | 198.3 | 200.7 | 101.2% | 69.8 | 0.59 |
| Example 1-2 | UDL-2 | 200.2 | 202.4 | 101.1% | 58.7 | 0.58 |
| Example 1-3 | UDL-3 | 196.0 | 200.5 | 102.3% | 60.3 | 0.59 |
| Example 1-4 | UDL-4 | 200.1 | 203.1 | 101.5% | 61 | 0.63 |
| Example 1-5 | UDL-5 | 201.2 | 203.8 | 101.3% | 59.3 | 0.62 |
| Example 1-6 | UDL-6 | 199.7 | 203.3 | 101.8% | 60.6 | 0.67 |
| Example 1-7 | UDL-7 | 202.5 | 209.4 | 103.4% | 57.6 | 0.58 |
| Example 1-8 | UDL-8 | 197.8 | 203.5 | 102.9% | 65.9 | 0.67 |
| Example 1-9 | UDL-9 | 203.4 | 209.9 | 103.2% | 56.7 | 0.66 |
| Example 1-10 | UDL-10 | 198.9 | 205.1 | 103.1% | 55.6 | 0.62 |
| Example 1-11 | UDL-11 | 202.7 | 210.0 | 103.6% | 58.4 | 0.6 |
| Example 1-12 | UDL-12 | 204.1 | 212.7 | 104.2% | 61.3 | 0.6 |
| Example 1-13 | UDL-13 | 199.1 | 208.1 | 104.5% | 60.2 | 0.62 |
| Example 1-14 | UDL-14 | 197.3 | 201.8 | 102.3% | 61.5 | 0.61 |
| Example 1-15 | UDL-15 | 198.0 | 203.0 | 102.5% | 58.4 | 0.6 |
| Example 1-16 | UDL-16 | 201.4 | 208.9 | 103.7% | 58.1 | 0.6 |
| Example 1-17 | UDL-17 | 202.9 | 209.6 | 103.3% | 59.4 | 0.6 |
| Example 1-18 | UDL-18 | 200.5 | 202.3 | 100.9% | 53.7 | 0.76 |
| Example 1-19 | UDL-19 | 198.4 | 201.0 | 101.3% | 53.9 | 0.69 |
| Example 1-20 | UDL-20 | 200.6 | 204.4 | 101.9% | 57.2 | 0.65 |
| Example 1-21 | UDL-21 | 201.0 | 206.6 | 102.8% | 56 | 0.64 |
| Example 1-22 | UDL-22 | 201.2 | 209.2 | 104.0% | 58 | 0.65 |
| Example 1-23 | UDL-23 | 200.7 | 210.1 | 104.7% | 58.3 | 0.59 |
| Example 1-24 | UDL-24 | 197.3 | 204.2 | 103.5% | 57.8 | 0.66 |
| Example 1-25 | UDL-25 | 198.2 | 204.3 | 103.1% | 58.4 | 0.61 |
| Example 1-26 | UDL-26 | 197.9 | 204.0 | 103.1% | 57 | 0.62 |
| Comparative Example 1-1 | Comparative UDL-1 | 198.6 | 199.0 | 100.2% | 54.8 | 0.7 |
| Comparative Example 1-2 | Comparative UDL-2 | 200 | 200.6 | 100.2% | 72.6 | 0.6 |
| Comparative Example 1-3 | Comparative UDL-3 | 200.4 | 200.2 | 99.9% | 69.5 | 0.55 |
| Comparative Example 1-4 | Comparative UDL-4 | - | - | - | - | - |

As shown in Table 2, regarding the inventive compositions for forming a resist underlayer film (Examples 1-1 to 1-26), the film remaining rate ((FT-2/FT-1)×100) between before and after the reworking was over 101% in every case, and it was suggested that the baked film was a porous film having many pores that OK73 thinner could soak into. Furthermore, out of the Examples where a polyether compound having a spirocyclic structure in the mother nucleus was used, in Examples 1-9 to 1-17, the film remaining percentage ((FT-2/FT-1)×100) was over 102%, and it was suggested that the porosity was further enhanced by the effects of the cyclic alkyl structure contained in the mother nucleus and the cyclic alkyl ether. Meanwhile, in Examples 1-18 to 1-20, where a crosslinking agent was contained, the film remaining percentage ((FT-2/FT-1)×100) between before and after the reworking was slightly lowered compared to the corresponding Examples 1-6, 1-9, and 1-11, where a crosslinking agent was not contained. Meanwhile, in Examples 1-21 to 1-23, where a thermally decomposable resin was contained, the film remaining percentage ((FT-2/FT-1)×100) between before and after the reworking was higher than in the corresponding Examples 1-6, 1-9, and 1-11, where a thermally decomposable resin was not contained. From the above, it can be seen that it is possible to adjust the porosity by adding a crosslinking agent and a thermally decomposable resin.

Improvement in film remaining percentage was not observed in Comparative Example 1-1, using a novolak resin containing a similar mother nucleus and having an ether substituent introduced, and in Comparative Example 1-2, using a novolak resin in which the hydroxy groups were left as they were. From these results, it was suggested that a polyether structure was important for achieving porousness.

In Comparative Example 1-3, the film remaining percentage was 99.9%, and was remarkably low.

Furthermore, in Comparative Example 1-4, using a polyether compound containing no aromatic rings, drastic sublimation occurred, and it was not possible to carry out the measurements. Thus, it was confirmed that the introduction of an aromatic ring is effective not only for processing resistance but also for the suppression of sublimation products etc.

Meanwhile, to compare the contact angle in Example 1-1, where fluorine was introduced, and Example 1-2, where fluorine was not introduced, there was a difference of about 10 degrees, and it was also confirmed that it may be possible to determine which kind to use depending on the hydrophilicity and hydrophobicity of the kind of gas to be used.

In addition, in Examples 1-1 to 1-26, hardness, which was measured as an index of processing resistance, exceeded 0.55 GPa and there was also a case where hardness exceeded 0.7 GPa, and therefore, it was also confirmed that sufficient processing resistance was provided.

### [Filling Property Evaluation]

Each of the compositions (UDL-1 to -26 and comparative UDL-2 and -3) for forming a resist underlayer film prepared above was respectively applied onto an SiO₂ wafer substrate having a dense hole pattern (hole diameter = 0.16 um, hole depth = 0.50 um, distance between the centers of two adjacent holes 0.32 pm), and the coating film was baked at 180°C for 60 seconds and then further baked at 350°C for 60 seconds. Thus, each resist underlayer film having a film thickness of 200 nm was respectively formed on a substrate having a dense hole pattern.

The cross-sectional shape of each of the obtained wafer substrates was observed using an electron microscope (S-4700) manufactured by Hitachi, Ltd., and it was confirmed whether the inside of the holes was filled with the organic film without voids (gaps). The results are shown in Table 3 below. When a composition for forming a resist underlayer film having a poor filling property is used, voids are generated inside the holes. In this evaluation, when a composition for forming a resist underlayer film having a desirable filling property is used, the organic film fills the inside of the holes without voids. The evaluation is as follows. A: filling was possible without voids, B: minute voids were present, C: voids were present or filling was not possible.

**[Table 3]**

| Example | Composition for forming resist underlayer film | Filling Property |
|---|---|---|
| Example 2-1 | UDL-1 | A |
| Example 2-2 | UDL-2 | A |
| Example 2-3 | UDL-3 | A |
| Example 2-4 | UDL-4 | A |
| Example 2-5 | UDL-5 | A |
| Example 2-6 | UDL-6 | A |
| Example 2-7 | UDL-7 | A |
| Example 2-8 | UDL-8 | A |
| Example 2-9 | UDL-9 | A |
| Example 2-10 | UDL-10 | A |
| Example 2-11 | UDL-11 | A |
| Example 2-12 | UDL-12 | A |
| Example 2-13 | UDL-13 | A |
| Example 2-14 | UDL-14 | A |
| Example 2-15 | UDL-15 | A |
| Example 2-16 | UDL-16 | A |
| Example 2-17 | UDL-17 | B |
| Example 2-18 | UDL-18 | A |
| Example 2-19 | UDL-19 | A |
| Example 2-20 | UDL-20 | A |
| Example 2-21 | UDL-21 | A |
| Example 2-22 | UDL-22 | A |
| Example 2-23 | UDL-23 | A |
| Example 2-24 | UDL-24 | A |
| Example 2-25 | UDL-25 | A |
| Example 2-26 | UDL-26 | A |
| Comparative Example 2-1 | Comparative UDL-2 | C |
| Comparative Example 2-2 | Comparative UDL-3 | B |

As shown in Table 3, in Examples 2-1 to 2-26, where the inventive compositions (UDL-1 to -26) for forming a resist underlayer film were used, voids were not generated except in Example 2-17, and it was confirmed that it was possible to fill the dense hole pattern and that an excellent filling property was successfully realized. In Example 2-17, where voids were observed, a polymer having a molecular weight of 13500 was used, and it is thought that the holes were not filled well to the bottom and voids were appeared to be present because the molecular weight was too large. Meanwhile, voids were not observed even in compositions containing a crosslinking agent or a thermally decomposable resin.

In Comparative Example 2-1, where the comparative UDL-2 was used, filling had not been accomplished. This is thought to be because the compound R-2 of the comparative UDL-2 did not have an ether substituent and the resin structure remained rigid, so that the flowability of the resin was low, and it was not possible to fill the inside of the fine pattern with the resin.

Meanwhile, in Comparative Example 2-2, where the comparative UDL-3 was used, voids larger than those in Example 2-17 were observed at the bottom. This is thought to be because the resin of the comparative UDL-3 did not have a crosslinking property in the resin itself and large amounts of a crosslinking agent and a thermal acid generator were added, leading to the decomposition of a large amount of the resin or the additives and a large amount of sublimation products.

### [Planarizing Property Evaluation]

Each of the compositions for forming a resist underlayer film prepared above was respectively applied onto an SiO₂ wafer substrate having a giant isolated trench pattern (trench width: 10 um, trench depth: 0.1 µm), and the obtained coating film was baked at 180°C for 60 seconds and then further baked at 350°C for 60 seconds. In this manner, each resist underlayer film was formed respectively on a substrate having a giant isolated trench pattern. The step between the trench portion and the non-trench portion of the resist underlayer film was observed using an atomic force microscope (AFM) NX10 manufactured by Park Systems. The results are shown in Table 4. In this evaluation, it can be said that the smaller the step, the better the planarizing property. Note that, in this evaluation, a trench pattern having a depth of 0.10 um was generally planarized using a composition for forming an organic film at a film thickness of approximately 0.2 um, and this is a severe evaluation condition to evaluate the planarizing property.

**[Table 4]**

| Example | Composition for forming resist underlayer film | Flatness |
|---|---|---|
| | | nm |
| Example 3-1 | UDL-6 | 40 |
| Example 3-2 | UDL-9 | 35 |
| Example 3-3 | UDL-11 | 40 |
| Example 3-4 | UDL-15 | 35 |
| Example 3-5 | UDL-16 | 35 |
| Example 3-6 | UDL-18 | 40 |
| Example 3-7 | UDL-19 | 40 |
| Example 3-8 | UDL-20 | 40 |
| Example 3-9 | UDL-21 | 35 |
| Example 3-10 | UDL-22 | 35 |
| Example 3-11 | UDL-23 | 40 |
| Example 3-12 | UDL-24 | 35 |
| Example 3-13 | UDL-25 | 35 |
| Example 3-14 | UDL-26 | 40 |
| Comparative Example 3-1 | Comparative UDL-1 | 45 |
| Comparative Example 3-2 | Comparative UDL-2 | 55 |
| Comparative Example 3-3 | Comparative UDL-3 | 100 |

As shown in Table 4, in Examples 3-1 to 3-5, where each of the compositions (UDL-6, -9, -11, -15, and -16) for forming a resist underlayer film, which are examples of the present invention, were used, it was confirmed that flatness was considerably better than in Comparative Example 3-3, where the resin structure was considerably different. It was also confirmed that the step in the film between the patterned portion and the non-patterned portion was smaller and the planarizing property was better even when compared to Comparative Examples 3-1 and 3-2, where a novolak resin was produced using a similar mother nucleus. Furthermore, in Examples 3-4 and 3-5, where UDL-15 and -16, containing multiple Ar₁ structures or R₁ structures were used, flatness was improved. This is thought to be the result of flowability being promoted by a combination of two kinds being contained. Meanwhile, comparing Examples 3-6 to -11 and Example 3-14, where the crosslinking agent (D-1) or the thermally decomposable resin (E-1) was contained, with Examples 3-1 to 3-3, where the additives were not contained, there was no great change in flatness, and it can be assumed that adding a crosslinking agent or a thermally decomposable resin, with which it is possible to adjust the porosity of the film, does not affect flatness. Meanwhile, in Examples 3-12 and 3-13, where the high-boiling-point solvent (B2-1) was contained, improvement in flatness was observed compared to Examples 3-2 and 3-3, where the high-boiling-point solvent (B2-1) was not contained. The main factor for this is assumed to be an improvement in thermal flowability caused by the high-boiling-point solvent.

From the above, the inventive composition for forming a resist underlayer film can provide a resist underlayer film that exhibits high filling and planarizing properties usable for an underlayer film, has high hardness and excellent processing resistance, and is also excellent in gas permeability, since a porous and low-density film can be formed. Such a resist underlayer film is particularly useful in nanoimprinting methods, and is also suitable for use in multilayer resist processes.

The present description includes the following embodiments.
[1] A composition for forming a resist underlayer film, comprising:
   (A) a polyether compound containing a repeating unit represented by the following general formula (I); and
   (B) an organic solvent, 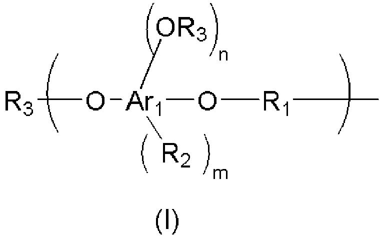
   wherein Ar₁ represents a substituted or unsubstituted aryl group having 6 to 30 carbon atoms, a substituted or unsubstituted heteroaryl group having 6 to 30 carbon atoms, a substituted or unsubstituted aryl group having 6 to 30 carbon atoms fused or linked with an aliphatic ring or a heterocycle, or a plurality of substituted or unsubstituted aryl groups each having 6 to 30 carbon atoms and linked with each other via a linear, branched, or cyclic hydrocarbon group, an ether group, or a carbonyl group, Ar₁ being of one kind or a combination of two or more kinds within a single resin, R₁ represents a substituted or unsubstituted, linear, branched, or cyclic, saturated or unsaturated divalent hydrocarbon group having 1 to 20 carbon atoms or a substituted or unsubstituted, linear, branched, or cyclic heteroalkylene group having 1 to 20 carbon atoms, R₂ represents a substituted or unsubstituted, linear, branched, or cyclic, saturated or unsaturated hydrocarbon group having 1 to 20 carbon atoms, a substituted or unsubstituted heteroalkyl group having 1 to 20 carbon atoms, an amino group, a thiol group, or a halogen atom, R₃ is of one kind or a combination of two or more kinds within a single resin and represents a hydrogen atom, a substituted or unsubstituted, linear, branched, or cyclic alkyl group having 1 to 20 carbon atoms, a substituted or unsubstituted, linear, branched, or cyclic alkenyl group having 2 to 20 carbon atoms, or a substituted or unsubstituted, linear, branched, or cyclic alkynyl group having 2 to 20 carbon atoms, and "n" and "m" each represent an integer of 0 or more.
[2] The composition for forming a resist underlayer film according to [1], wherein at least one of the R₃ in the general formula (I) is a structure R_{II-1} selected from the group consisting of groups represented by the following formulae (II-1), and a proportion "a" of the structure R_{II-1} is 1 ≤ a ≤ 100, 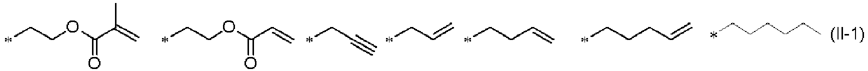 wherein "*" represents an attachment point to the oxygen atom.
[3] The composition for forming a resist underlayer film according to [1], wherein the R₃ in the general formula (I) is a combination of a structure R_{II-1} selected from the group consisting of groups represented by the following formulae (II-1) and a structure R_{II-2} selected from the group consisting of groups represented by the following formulae (II-2), and a proportion "a" of the structure R_{II-1} and a proportion "b" of the structure R_{II-2} satisfy relationships 1 ≤ a ≤ 99, 1 ≤ b ≤ 99, and a + b = 100, 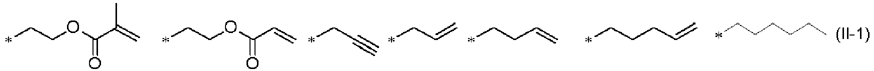 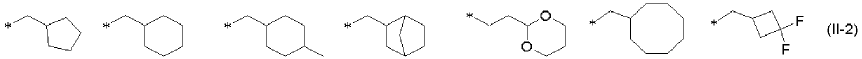 wherein "*" represents an attachment point to the oxygen atom.
[4] The composition for forming a resist underlayer film according to any one of [1] to [3], wherein the R₁ in the general formula (I) is selected from the group consisting of groups represented by the following general formulae (III-1) to (III-3), 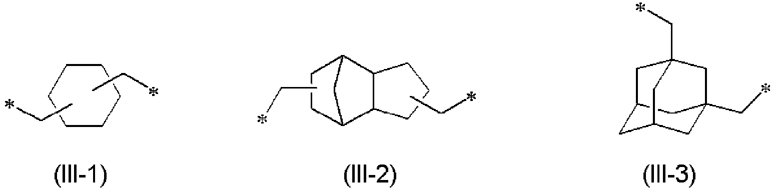 wherein "*" represents an attachment point to the oxygen atom.
[5] The composition for forming a resist underlayer film according to any one of [1] to [4], wherein the Ar₁ in the general formula (I) is selected from the group consisting of structures represented by the following formulae (Ar-1), 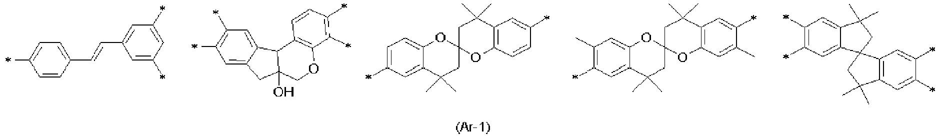 wherein "*" represents an attachment point to the oxygen atom of the -O-R₁- or OR₃.
[6] The composition for forming a resist underlayer film according to any one of [1] to [5], wherein the polyether compound has a weight-average molecular weight Mw of 2000 to 12000 as measured by gel permeation chromatography in terms of polystyrene.
[7] The composition for forming a resist underlayer film according to any one of [1] to [6], wherein
   101 < {(FT-2)/(FT-1)} × 100 is satisfied,
   wherein the FT-1 is a film thickness of a coating film of the composition for forming a resist underlayer film applied onto a substrate, the coating film having been subjected to baking at 180°C for 60 seconds and additional baking at 350°C for 60 seconds, and
   the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.
[8] The composition for forming a resist underlayer film according to any one of [1] to [7], further comprising (C) a surfactant.
[9] The composition for forming a resist underlayer film according to any one of [1] to [6], further comprising (D) a crosslinking agent, wherein
   100 < {(FT-2)/(FT-1)} × 100 < 103 is satisfied,
   wherein the FT-1 is a film thickness of a coating film of the composition for forming a resist underlayer film applied onto a substrate, the coating film having been subjected to baking at 180°C for 60 seconds and additional baking at 350°C for 60 seconds, and
   the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.
[10] The composition for forming a resist underlayer film according to any one of [1] to [6], further comprising (E) a thermally decomposable resin, wherein
   101.5 < {(FT-2)/(FT-1)} × 100 is satisfied,
   wherein the FT-1 is a film thickness of a coating film of the composition for forming a resist underlayer film applied onto a substrate, the coating film having been subjected to baking at 180°C for 60 seconds and additional baking at 350°C for 60 seconds, and
   the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.
[11] The composition for forming a resist underlayer film according to any one of [1] to [6], further comprising both (D) a crosslinking agent and (E) a thermally decomposable resin, wherein
   100 < {(FT-2)/(FT-1)} × 100 is satisfied,
   wherein the FT-1 is a film thickness of a coating film of the composition for forming a resist underlayer film applied onto a substrate, the coating film having been subjected to baking at 180°C for 60 seconds and additional baking at 350°C for 60 seconds, and
   the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.
[12] The composition for forming a resist underlayer film according to any one of [1] to [11], further comprising (F) an acid generator.
[13] The composition for forming a resist underlayer film according to any one of [1] to [12], wherein the composition for forming a resist underlayer film is for nanoimprinting.
[14] A resist underlayer film, being a cured product of a coating film comprising the composition for forming a resist underlayer film according to any one of [1] to [12].
[15] A method for manufacturing a resist underlayer film, comprising:
   applying the composition for forming a resist underlayer film according to any one of [1] to [12] onto a semiconductor substrate to obtain a coating film; and
   baking the coating film to obtain a resist underlayer film.
[16] A patterning process comprising the steps of:
   forming a resist underlayer film on a semiconductor substrate by using the composition for forming a resist underlayer film according to any one of [1] to [12];
   forming a curable composition film on the resist underlayer film;
   bringing the curable composition film into contact with a mold;
   irradiating the curable composition film with light or an electron beam to obtain a cured film; and
   separating the cured film from the mold.
[17] The patterning process according to [16], wherein the step of forming the curable composition film on the resist underlayer film includes: forming an adhesive layer and/or a silicone layer containing 99 mass% or less Si on the resist underlayer film by application or deposition; and forming the curable composition film thereon.
[18] A method for manufacturing a semiconductor device, comprising the steps of:
   forming a resist underlayer film on a semiconductor substrate by using the composition for forming a resist underlayer film according to any one of [1] to [12];
   forming a resist film on the resist underlayer film;
   subjecting the resist film to irradiation with light or an electron beam and then to development to form a resist pattern;
   etching the resist underlayer film while using the formed resist pattern as a mask to obtain a patterned underlayer film; and
   processing the semiconductor substrate while using the patterned underlayer film as a mask.
[19] A method for manufacturing a semiconductor device, comprising the steps of:
   forming a resist underlayer film on a semiconductor substrate by using the composition for forming a resist underlayer film according to any one of [1] to [12];
   forming a hard mask on the resist underlayer film;
   further forming a resist film on the hard mask;
   subjecting the resist film to irradiation with light or an electron beam and then to development to form a resist pattern;
   etching the hard mask while using the formed resist pattern as a mask to obtain a patterned hard mask;
   etching the underlayer film while using the patterned hard mask as a mask to obtain a patterned resist underlayer film; and
   processing the semiconductor substrate while using the patterned resist underlayer film as a mask.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming a resist underlayer film, comprising:
(A) a polyether compound containing a repeating unit represented by the following general formula (I); and
(B) an organic solvent, 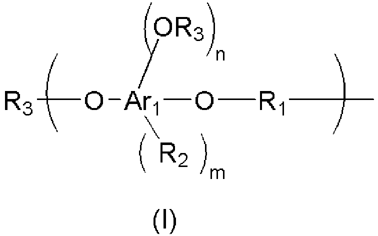
wherein Ar₁ represents a substituted or unsubstituted aryl group having 6 to 30 carbon atoms, a substituted or unsubstituted heteroaryl group having 6 to 30 carbon atoms, a substituted or unsubstituted aryl group having 6 to 30 carbon atoms fused or linked with an aliphatic ring or a heterocycle, or a plurality of substituted or unsubstituted aryl groups each having 6 to 30 carbon atoms and linked with each other via a linear, branched, or cyclic hydrocarbon group, an ether group, or a carbonyl group, Ar₁ being of one kind or a combination of two or more kinds within a single resin, R₁ represents a substituted or unsubstituted, linear, branched, or cyclic, saturated or unsaturated divalent hydrocarbon group having 1 to 20 carbon atoms or a substituted or unsubstituted, linear, branched, or cyclic heteroalkylene group having 1 to 20 carbon atoms, R₂ represents a substituted or unsubstituted, linear, branched, or cyclic, saturated or unsaturated hydrocarbon group having 1 to 20 carbon atoms, a substituted or unsubstituted heteroalkyl group having 1 to 20 carbon atoms, an amino group, a thiol group, or a halogen atom, R₃ is of one kind or a combination of two or more kinds within a single resin and represents a hydrogen atom, a substituted or unsubstituted, linear, branched, or cyclic alkyl group having 1 to 20 carbon atoms, a substituted or unsubstituted, linear, branched, or cyclic alkenyl group having 2 to 20 carbon atoms, or a substituted or unsubstituted, linear, branched, or cyclic alkynyl group having 2 to 20 carbon atoms, and "n" and "m" each represent an integer of 0 or more.

2. The composition for forming a resist underlayer film according to claim 1, wherein
i) at least one of the R₃ in the general formula (I) is a structure R_{II-1} selected from the group consisting of groups represented by the following formulae (II-1), and a proportion "a" of the structure R_{II-1} is 1 ≤ a ≤ 100, 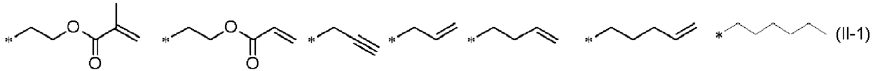 wherein "*" represents an attachment point to the oxygen atom; or
ii) the R₃ in the general formula (I) is a combination of a structure R_{II-1} selected from the group consisting of groups represented by the following formulae (II-1) and a structure R_{II-2} selected from the group consisting of groups represented by the following formulae (II-2), and a proportion "a" of the structure R_{II-1} and a proportion "b" of the structure R_{II-2} satisfy relationships 1 ≤ a ≤ 99, 1 ≤ b ≤ 99, and a + b = 100, 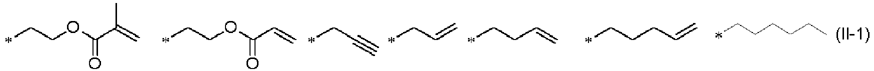 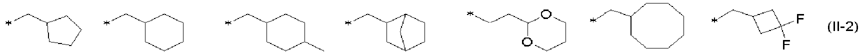 wherein "*" represents an attachment point to the oxygen atom.

3. The composition for forming a resist underlayer film according to claim 1 or 2, wherein the R₁ in the general formula (I) is selected from the group consisting of groups represented by the following general formulae (III-1) to (III-3), 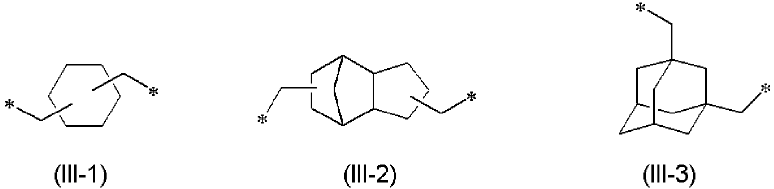
wherein "*" represents an attachment point to the oxygen atom; and/or
wherein the Ar₁ in the general formula (I) is selected from the group consisting of structures represented by the following formulae (Ar-1), 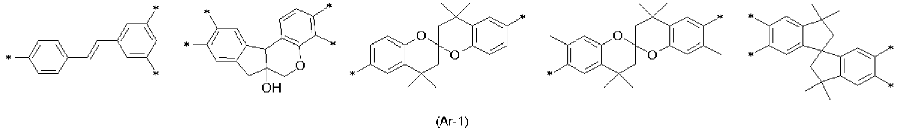
wherein "*" represents an attachment point to the oxygen atom of the -O-R₁- or OR₃.

4. The composition for forming a resist underlayer film according to any one of claims 1 to 3, wherein the polyether compound has a weight-average molecular weight Mw of 2000 to 12000 as measured by gel permeation chromatography in terms of polystyrene.

5. The composition for forming a resist underlayer film according to any one of claims 1 to 4, wherein
101 < {(FT-2)/(FT-1)} × 100 is satisfied,
wherein the FT-1 is a film thickness of a coating film of the composition for forming a resist underlayer film applied onto a substrate, the coating film having been subjected to baking at 180°C for 60 seconds and additional baking at 350°C for 60 seconds, and
the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.

6. The composition for forming a resist underlayer film according to any one of claims 1 to 5, further comprising (C) a surfactant.

7. The composition for forming a resist underlayer film according to any one of claims 1 to 4, further comprising (D) a crosslinking agent, wherein 100 < {(FT-2)/(FT-1)} × 100 < 103 is satisfied,
wherein the FT-1 is a film thickness of a coating film of the composition for forming a resist underlayer film applied onto a substrate, the coating film having been subjected to baking at 180°C for 60 seconds and additional baking at 350°C for 60 seconds, and
the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.

8. The composition for forming a resist underlayer film according to any one of claims 1 to 4, further comprising
i)
(E) a thermally decomposable resin, wherein
101.5 < {(FT-2)/(FT-1)} × 100 is satisfied,
wherein the FT-1 is a film thickness of a coating film of the composition for forming a resist underlayer film applied onto a substrate, the coating film having been subjected to baking at 180°C for 60 seconds and additional baking at 350°C for 60 seconds, and
the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner; or
ii)
both (D) a crosslinking agent and (E) a thermally decomposable resin, wherein
100 < {(FT-2)/(FT-1)} × 100 is satisfied,
wherein the FT-1 is a film thickness of a coating film of the composition for forming a resist underlayer film applied onto a substrate, the coating film having been subjected to baking at 180°C for 60 seconds and additional baking at 350°C for 60 seconds, and
the FT-2 is a film thickness of the coating film, having been subjected to, after the additional baking, dispensing of OK73 thinner, being a mixture of propylene glycol monomethyl ether and propylene glycol monomethyl ether acetate in a ratio of 7:3, been left to stand for 30 seconds, been subjected to spin-drying, and been subjected to baking at 100°C for 60 seconds to evaporate the OK73 thinner.

9. The composition for forming a resist underlayer film according to any one of claims 1 to 8, further comprising (F) an acid generator.

10. The composition for forming a resist underlayer film according to any one of claims 1 to 9, wherein the composition for forming a resist underlayer film is for nanoimprinting.

11. A resist underlayer film, being a cured product of a coating film comprising the composition for forming a resist underlayer film according to any one of claims 1 to 9.

12. A method for manufacturing a resist underlayer film, comprising:
applying the composition for forming a resist underlayer film according to any one of claims 1 to 9 onto a semiconductor substrate to obtain a coating film; and
baking the coating film to obtain a resist underlayer film.

13. A patterning process comprising the steps of:
forming a resist underlayer film on a semiconductor substrate by using the composition for forming a resist underlayer film according to any one of claims 1 to 9;
forming a curable composition film on the resist underlayer film;
bringing the curable composition film into contact with a mold;
irradiating the curable composition film with light or an electron beam to obtain a cured film; and
separating the cured film from the mold.

14. The patterning process according to claim 13, wherein the step of forming the curable composition film on the resist underlayer film includes: forming an adhesive layer and/or a silicone layer containing 99 mass% or less Si on the resist underlayer film by application or deposition; and forming the curable composition film thereon.

15. A method for manufacturing a semiconductor device, comprising the steps of:
forming a resist underlayer film on a semiconductor substrate by using the composition for forming a resist underlayer film according to any one of claims 1 to 9; and:
i)
forming a resist film on the resist underlayer film;
subjecting the resist film to irradiation with light or an electron beam and then to development to form a resist pattern;
etching the resist underlayer film while using the formed resist pattern as a mask to obtain a patterned underlayer film; and
processing the semiconductor substrate while using the patterned underlayer film as a mask; or
ii)
forming a hard mask on the resist underlayer film;
further forming a resist film on the hard mask;
subjecting the resist film to irradiation with light or an electron beam and then to development to form a resist pattern;
etching the hard mask while using the formed resist pattern as a mask to obtain a patterned hard mask;
etching the underlayer film while using the patterned hard mask as a mask to obtain a patterned resist underlayer film; and
processing the semiconductor substrate while using the patterned resist underlayer film as a mask.
